(19) Europäisches Patentamt
European Patent Office
Office européen des brevets

(11) **EP 4 589 236 A1**

(12) **EUROPEAN PATENT APPLICATION**

(43) Date of publication:
**23.07.2025 Bulletin 2025/30**

(21) Application number: **25151227.3**

(22) Date of filing: **10.01.2025**

(51) International Patent Classification (IPC):
**F28D 21/00** (2006.01)  **F24D 18/00** (2022.01)
**H10N 10/13** (2023.01)  **E03C 1/12** (2006.01)
**F24D 101/60** (2022.01)

(52) Cooperative Patent Classification (CPC):
**F24D 18/00; E03C 1/00; E03C 1/12; H10N 10/13;**
F24D 2101/60; F24D 2200/20; F24H 2240/08

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **19.01.2024 US 202463623031 P**
**27.12.2024 US 202419003019**

(71) Applicant: **Kohler Co.**
**Kohler, WI 53044 (US)**

(72) Inventors:
• **KURU, William C.**
**Kohler, Wisconsin 53044 (US)**
• **KWACZ, Jason M.**
**Kohler, Wisconsin 53044 (US)**
• **WHITFIELD, Robin**
**Kohler, Wisconsin 53044 (US)**
• **KAJUCH, Peter**
**Kohler, Wisconsin 53044 (US)**

(74) Representative: **Barker Brettell LLP**
**100 Hagley Road**
**Edgbaston**
**Birmingham B16 8QQ (GB)**

(54) **WASTE WATER HEAT RECOVERY**

(57)    A plumbing fixture includes a water passage configured to hold water, a first plate shaped according to a cross section of the water passage and spaced at a first distance from the water passage, and a second plate shaped according to the cross section of the water passage and spaced at a second distance from the water passage. A voltage between the first plate and the second plate is generated based on the water in the water passage.

FIG. 1

## Description

### CROSS REFERENCE TO RELATED APPLICATION

This application claims the benefit of priority to U.S. Provisional Application No. 63/623,031 filed on January 19, 2024, and U.S. Patent Application No. 19/003,019 filed on December 27, 2024, which are hereby incorporated by reference in their entirety.

### FIELD

The present application relates generally to the field of water thermal recycling in water consuming appliances and plumbing fixtures.

### BACKGROUND

Water is heated for many household applications or appliances such as a dishwasher, a lavatory, a shower, etc. Thermal energy is applied to the water upstream of the appliance, usually via a water heater. After the intended use of the water, energy is lost when heated water escapes down the drain to the sewer or other wastewater disposal. Water thermal recycling employs apparatus and techniques to recover the energy before it leaves the home or other building. The following embodiments include improvements to water thermal recycling apparatus and techniques.

### BRIEF DESCRIPTION OF THE DRAWINGS

Exemplary embodiments are described herein with reference to the following drawings, according to an exemplary embodiment.

FIG. 1 illustrates an example electrical energy extraction device for a plumbing fixture.

FIG. 2A-2F illustrates example cross sections for the plumbing fixture of FIG. 1.

FIG. 3 illustrates an example water recycling system.

FIG. 4 illustrates an example toilet including an electrical energy extraction device.

FIG. 5 illustrates an example lavatory connected to an electrical energy extraction device.

FIG. 6 illustrates example kitchen appliances including an electrical energy extraction device.

FIG. 7 illustrates example shower appliances for use with an electrical energy extraction device.

FIG. 8 illustrates an example bathtub for use with an electrical energy extraction device.

FIG. 9 illustrates an example bidet for use with an electrical energy extraction device.

FIG. 10 illustrates an example thermal recovery device.

FIG. 11 illustrates an example thermal recovery system.

FIG. 12 illustrates an example thermal recovery system.

FIG. 13 illustrates an example thermal recovery system.

FIG. 14A illustrates an example plumbing fixture for the thermal recovery device.

FIG. 14B illustrates another example plumbing fixture for the thermal recovery device.

FIG. 15A illustrates another example plumbing fixture for the thermal recovery device.

FIG. 15B illustrates another example plumbing fixture for the thermal recovery device.

FIG. 15C illustrates another example plumbing fixture for the thermal recovery device.

FIG. 16 illustrates an example alert device for a waste water heat recovery system.

FIG. 17 illustrates an example thermal recovery device for a compost system.

FIG. 18 illustrates an example controller for any of the thermal recycling system.

FIG. 19 illustrates an example flow chart for the controller of FIG. 18.

FIG. 20 illustrates another example flow chart for the controller of FIG. 18.

FIG. 21 illustrates another example flow chart for the controller of FIG. 18.

FIG. 22 illustrates another example flow chart for the controller of FIG. 18.

### DETAILED DESCRIPTION

The following embodiments include devices and techniques for the recovery of energy from water stored in or passing through a plumbing fixture or plumbing device. If the energy can be recovered before the water leaves the home, the costs of heating the water supply is reduced. In many cases, the energy is recovered from waste water that has a temperature higher than that of the ambient environment. In other cases, the energy may be recovered from water colder than the ambient environment. The following embodiments include plumbing devices such as faucets, toilets, bathtubs, and showers. The term "plumbing fixture" encompasses plumbing devices and refers to an apparatus that is connected to a plumbing system of a house, building or another structure. Plumbing fixtures include pipes and other apparatuses that water flows through such as a mixing valve.

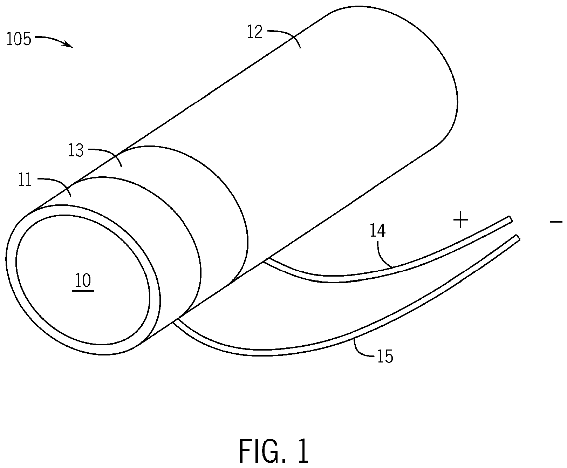

FIG. 1 illustrates an example electrical energy extraction device 103 for a plumbing fixture. The electrical energy extraction device 103 includes a water passage 10, a first plate 11, a second plate 12, a paste 13, a first wire 14, and a second wire 15. Additional, different, or fewer components may be included.

The first plate 11 and the second plate 12 may be shaped as a pipe. That is, the first plate 11 and the second plate 12 may be cylindrical. The first plate 11 may form the inner surface of the plumbing fixture or pipe. The first plate 11 and second plate 12 may form a section of the pipe such that the water passage 10 passes through the first plate 11 and the second plate 12. The first plate 11 and the second plate 12 are shaped according to the cross section of the water passage 10. In some examples, the first plate 11 may be adhered or otherwise coupled to the inside of a pipe, and the second plate 12 may be adhered or otherwise coupled to the outside of the pipe.

The first plate 11 is spaced a first distance from the water passage 10 (e.g., the water may contact the first plate 11 or the water may contact an intermediate layer or coating that transfers thermal energy from the water to the first plate 11). The second plate 12 is spaced at a second distance from the water passage.

The first plate 11 and the second plate 12 may form a thermoelectric cell. The cell may be cylindrical. The first plate 11 and the second plate 12 are formed from dissimilar metals. Examples include bismuth telluride ($Bi_2Te_3$), bismuth selenide ($Bi_2Se_3$), and lead tellurides (PbTe). In addition, nanostructuring these materials to produce a layered superlattice structure of alternating bismuth telluride ($Bi_2Te_3$) and bismuth selenide ($Bi_2Se_3$) may applied to the first plate 11 and/or the second plate 12.

When the first plate 11 and the second plate 12 are subjected to a temperature difference, an electrical current is generated in the cell and travels through wires 14 and 15 and associated electrical load. The cell may demonstrate the Peltier effect (e.g., in addition to, or in the alternative of, the Seebeck effect and/or the Thomson effect). An electromotive force develops across two points in a conductive material when there is a temperatures difference between those points. As described above, in some examples, the cell forms water passage 10. The first plate 11 is subjected to the water inside the water passage 10. The second plate 12 is subjected to the ambient temperature.

In many instances, the water traveling through the water passage 10 is warmer than the ambient environment, causing the cell to generate an electric current. The current may be small but sufficient to operate low power electronics. These electronics may include light emitting diodes (LEDs), radios, segment displays, or other circuitry. The current may be used to charge a battery. The water passage 10 may be associated to wastewater. The wastewater may be warm and be considered waste and destined for a sewer or other destination outside of the home or building. The following embodiments harness the heat of the wastewater to provide electrical power to one or more components.

The length of the electrical energy extraction device 103 along the pipe, or forming the pipe, may impact the voltage or current provided electrical energy extraction device 103. The cross section of the electrical energy extraction device 103 may also be change to increase the contact area of the electrical energy extraction device 103 and impact the induced voltage or current. Various cross-sections will also have an impact on reducing the thermal boundary layer in the water stream. As a consequence, the first plate, 11, will reach greater temperatures and the energy extraction will improve. A rectangular cross-section with a high aspect ratio would be most effective at this.

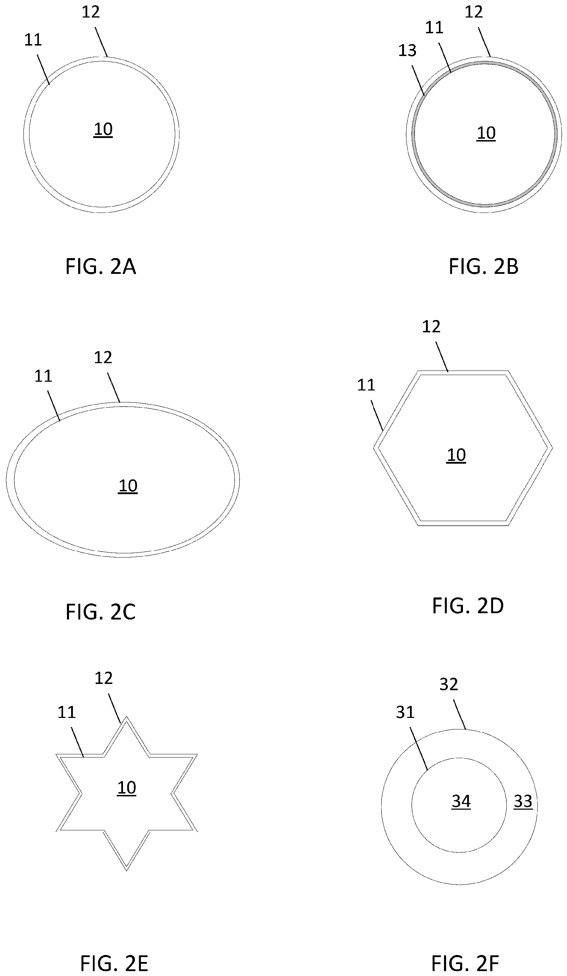

FIGS. 2A and 2B illustrate circular cross sectional areas for the electrical energy extraction device 103. In FIG. 2B, a paste 13 (e.g., a temperature efficient paste) may be placed between the first plate 11 and the second plate 12. Any of the examples herein may include the paste 13 or omit the paste 13.

FIG. 2C illustrates an example oval electrical energy extraction device 103. The oval shape has a greater surface area than the circular surface area. FIG. 2D illustrates a polygonal, such as a hexagon, cross section area for an electrical energy extraction device 103. The hexagonal cross section has more surface area per length than the circular cross sectional area. FIG. 2E illustrates a star-shaped cross section area for an electrical energy extraction device 103. The star-shaped cross section has more surface area per length than the circular or star-shaped cross sectional areas.

FIG. 2F illustrates another type of thermoelectric cell formed from concentric pipes. In this case, an inner pipe 31 forming a first passage 34, corresponds to the first plate 11. An outer pipe 32 forming a second passage 33, corresponds to the second plate 12. Thus, the inner pipe 31 and the outer pipe 32 are dissimilar metals that form a thermoelectric cell and generate an electrical current based on the temperature gradient between a liquid in the first passage 34 and the second passage 33. Both passages may carry water, one may carry water and the other a mixture of other materials. The flow in the first passage 34 and the second passage 33 may be in the same direction or opposite directions.

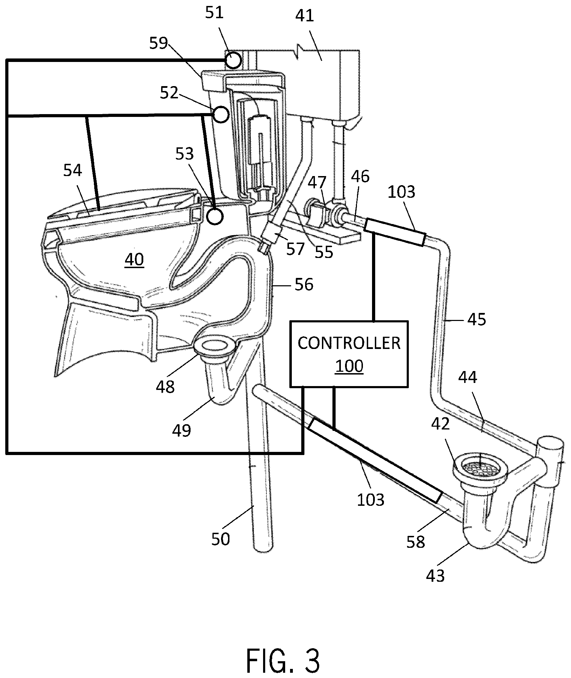

FIG. 3 illustrates an example toilet and water recycling system. The toilet includes a passage 56 (e.g., a trapway) that is configured to extend from a bowl 40 (e.g., the exit or outlet) to a drain pipe 49 (e.g., soil pipe) connected to the trapway 56 at a gasket 48 or other connector. The gasket 48 may be provided in the floor of the building (e.g., structure, dwelling, etc.) in which the toilet is being installed. The toilet may be configured as a siphoning toilet, where the passage 56 is configured as a siphoning trapway to create a siphon during a flushing cycle to evacuate the waste contents from the bowl 40 to the drain pipe 49.

The toilet may also include a grey water system that introduces grey water into the toilet. The grey water system may be configured to capture and store grey water recovered from a water consuming appliance such as a shower. According to an exemplary embodiment, the grey water system includes a collection device that is configured to capture or collect the grey water, a storage device that is configured to store the collected grey water prior to use, and a delivery device that is configured to introduce the grey water into the toilet during a flush cycle. It is noted that the toilets disclosed herein may include any one of any combination of the de storage, and collection devices/systems.

FIG. 3 includes a grey water system including a tank 41 and pipe 55 that is configured to introduce captured grey water into the trapway 56 of the toilet during a flush cycle. The grey water system includes a collection device in the form of a pipe 43 and a drain 42 that is configured to capture shower water from the bath/-shower. The grey water system may also include a pump 47 or other suitable device that is configured to move, such as through fluid pressure, the recycled shower water from the collection device to a storage device (e.g., tank 41). The tank 41 may be connected to the shower (e.g., via drain 42) using a supply pipe, including one or more of a first horizontal section 44, a vertical section 45 and/or a second horizontal section 46.

As shown the storage device is a container that is configured to hold a specified volume of grey water therein. The size (e.g., volume) of the storage device may be varied, such as, for the anticipated use of the toilet. In other words, the volume that the storage device can hold may be tailored to the specific application or type of dwelling in which the toilet is installed.

The toilet may include a valve 57 (e.g., valve assembly) disposed between an outlet of the storage device and the trapway 56, where the valve 57 controls the flow (e.g., the volume, the time, etc.) of the grey water from the storage device to the trapway 6. The valve 74 is configured to open and close to permit or prohibit (e.g., shut-off) the flow of the grey water therethrough. The valve 57 may be controlled mechanically, electronically, or a combination thereof, for example, using an actuator such as a lever arm, button, or other device. The actuator may be a button that is configured to send an electronic signal to a solenoid (or other suitable device) upon being depressed, where the solenoid controls the opening and closing of the valve 57, The timing of the valve 57, such as when to open and when to close, may be varied to tailor the operation of the valve 57 to the performance of the toilet. For example, the valve 57 may be opened approximately one to two seconds prior to the siphon. In other examples, the grey water system may be connected directly to a tank of the toilet or a rim channel of the toilet.

The grey water system may also include a dispensing subsystem for dispensing excess or additional grey water, such as when the storage device is full. The dispensing subsystem includes a first dispensing pipe connected to the tank, a second dispensing pipe 58, and a third dispensing pipe 50. The first dispensing pipe may fluidly connect the storage device and the third dispensing pipe 50. For example, the first dispensing pipe may be provided at a top portion of the storage device in order for excess grey water to drain from the storage device when the storage device is full.

The second dispensing pipe 58 may fluidly connect the collection device and the third dispensing pipe 50. For example, the second dispensing pipe 58 may be configured to direct excess grey water to the third dispensing pipe 50 when the storage device is full of grey water.

In one example, an electrical energy extraction device 103 is provided on (or integrated with) a dispensing pipe. For example, FIG. 3 includes electrical energy extraction device 103 at dispensing pipe 58. In one example, an electrical energy extraction device 103 is provided on (or integrated with) a supply pipe. These locations for the electrical energy extraction device 103 may be used individually in some embodiments or combined.

The controller 100 (e.g., control circuit) may direct electrical power to one or more electrical devices associated with the toilet or the grey water system. In some examples, the electrical power is stored in a battery and provided to electrical devices over time. In other examples, the electrical power is provided directly to the electrical device as it is generated.

The electrical devices may include indicator implemented as light emitting diodes (LEDs) or other lights.

A grey water tank indicator 51 may indicate whether water is available in the grew water tank 41 for flushing the toilet. The grey water tank indicator 51 may be electrically connected to a water level sensor in the tank 41.

A toilet indicator 52 may indicate whether water is available in the toilet tank 59 for flushing the toilet. The toilet indicator 52 may be electrically connected to a water level sensor in the toilet tank 59. The toilet indicator 52 may indicate a flush setting for the toilet (e.g., flush volume, cleaning). The toilet indicator 52 may include a night light. The night light may be electrically couple to a proximity sensor.

A bidet indicator or bidet device 53 may indicate whether water is heated in the bidet, or whether the bidet is powered on or activated. The bidet indicator may be electrically coupled to a water sensor for detecting water in the bidet. The bidet indicator 53 may be electrically coupled to a pressure sensor in the seat. The bidet indicator may be electrically coupled to the power circuit of the bidet device 53. The bidet device 53 may be configured to dispense water from the rear or front of the toilet bowl 40.

Alternatively, the bidet device 53 may be a heater, a pump, a light, or a fan in the bidet. That is, the controller 100 may provide the controller to one or more of the heater, the pump, the light or the fan in the bidet.

A toilet seat device 54 may include an indicator for a toilet seat indicating any of the toilet status or toilet settings described herein. The toilet seat device 54 may include a heater for toilet seat. Thus, the controller 100 is configured to provide the electric power from the electrical energy extraction device 103 to toilet seat. The toilet seat device 54 may include a sanitation device such as a mister or an ultraviolet light. The toilet seat device 54 may include a motor for raising and/or closing the toilet sat and/or a toilet seat cover.

The controller 100 (e.g., control circuit) regulates the current or voltage supplied by the electrical energy extraction device 103. The controller 100 may detect an electrical property of the generated current or voltage to provide the electrical power from the electrical energy extraction device 103 to the indicator or other electronic device. When the electrical property in the generated current or voltage exceeds a threshold, the controller 100 closes a switch to connect the electrical energy extraction device 103 to the indicator or the other electronic device.

The controller 100 may provide power to an actuator for flushing the toilet. The actuator may be a button that is configured to send an electronic signal to a solenoid (or other suitable device) upon being depressed, where the solenoid controls the opening and closing of a valve for the toilet tank 59 or the valve 57 for the grew water tank 41. The controller 100 may provide power to a solenoid for opening and closing a valve for a rim jet or a sump jet.

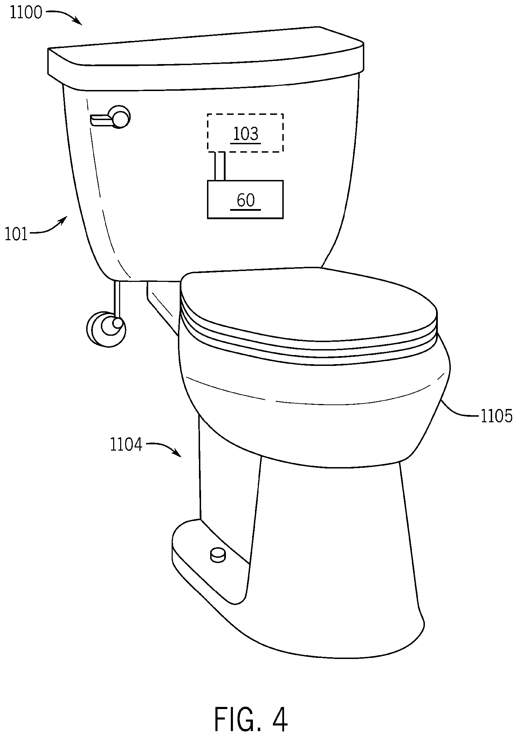

FIG. 4 illustrates an example toilet for use with an electrical energy extraction device 103 on water container. Referring to FIG. 4, a toilet 1100 with the electrical energy extraction device 103 is illustrated according to an exemplary embodiment of the present disclosure. The toilet 1100 may include a tank (e.g., container, reservoir, etc.), shown as a tank 101, and a pedestal (e.g., base, stand, support, etc.), shown as a pedestal 1104. The tank 101 may be coupled to, and supported by, the pedestal 1104, which may be positioned on a floor. In some embodiments, the tank 101 and the pedestal 1104 may be formed together as a single component. In some other examples, the tank 101 may be mounted nearby on a wall, or within a wall. The tank 101 is configured to receive water (e.g., via a fill valve of the toilet 1100, etc.) and store the water in between flushes. The pedestal 1104 includes a bowl 1105 and may be configured to receive the water from the tank 101 to flush contents of bowl into a sewage line. In some embodiments, the pedestal 1104 may be mounted on the wall of a lavatory and the bowl may be configured to receive water from a fluid supply source such as a household water supply.

The bowl 1105 of the pedestal 1104 includes a sump (e.g. a receptacle) and an outlet opening, wherein water and waste is collected in the sump until being removed through the outlet opening, such as when the contents of the bowl 1105 are flushed into a sewage line. The toilet 1100 further includes a trapway, and the trapway may be fluidly connected to the bowl 1105 via the sump. The trapway fluidly connects the sump to the outlet opening.

The electrical energy extraction device 103 may include a first plate on the inside of the tank 101 and a second plate on the outside of the tank 101. The water in the inside of the tank 101 may typically have a lower temperature than the air in the ambient environment of the toilet 1100 and the tank 101. A current is provided from the electrical energy extraction device 103 in response to the difference in temperature. The current may be provided to electronic device 60, which may include one or more displays, indicators, or inputs.

The displays or indicators may display status information for the toilet 1100. Status information may include a flush style selection or a current stage in the flush cycle. Example flush style selections may include low flush volume or high flush volume. Example flush style selections may include whether or not to add a chemical compound in the tank 101.

The inputs (e.g., touchscreen or buttons) may receive inputs or selections from a user. The user may select flush volumes, control a bidet, operate a heated seat, turn on a night light, or other functions. Any of the functions may be operated by a remote control device. The remote control device may be charged by the electronic device 60.

The electronic device 60 may be a cleaning compound generator configured to generate chlorine, ozone, or another cleaning substance. The electronic device 60 may apply a charge to the water to electrolyze the water.

The electronic device 60 may also monitor the electrical energy extraction device 103. The electronic device 60 may record the electrical current produced by the electrical energy extraction device 103. The electronic device 60 may determine whether an error or fault occurs in the electrical energy extraction device 103. The electronic device 60 may deactivate the electrical energy extraction device 103 in response to the error or fault. The electronic device 60 may activated or deactivate the electrical energy extraction device 103 in response to a user input.

The electronic device 60 may include sensors or otherwise receive sensor data. The sensors may be powered by the electrical energy extraction device 103. In the instance of automatic initiation of the flush cycle, the controller 100, may receive sensor data indicative of usage of the toilet. For example, the controller 100 may be in communication with a sensor configured to detect the presence of a user and initiate the flush cycle in response to a user leaving the vicinity of the toilet.

The sensor may include any type of sensor configured to detect certain actions and/or to provide functionality (e.g., dispensing, flushing, etc.). The sensor may include any type of sensor configured to detect certain conditions and/or to provide functionality. Odor sensors, proximity sensors, and motion sensors are non-limiting examples of sensors that may be employed with the systems of this application. Odor sensors, such as volatile organic compound (VOC) sensors, may be employed to detect organic chemicals and compounds, both human made and naturally occurring chemicals/compounds. Proximity sensors may be employed to detect the presence of an object within a zone of detection without physical contact between the object and the sensor. Electric potential sensors, capacitance sensors, projected capacitance sensors, and infrared sensors (e.g., projected infrared sensors, passive infrared sensors) are non-limiting examples of proximity sensors that may be employed with the systems of this application. Motion sensors may be employed to detect motion (e.g., a change in position of an object relative to the objects surroundings). Electric potential sensors, optic sensors, radio-frequency (RF) sensors, sound sensors, magnetic sensors (e.g., magnetometers), vibration sensors, and infrared sensors (e.g., projected infrared sensors, passive infrared sensors) are non-limiting examples of motion sensors that may be employed with the systems of this application.

In another example, the sensor may include a sensor configured to detect a water level of water. The sensor may include a float sensor, a pressure level sensor, an ultrasonic water level transmitter, a capacitance level sensor (e.g., an RF sensor), and a radar level sensor. Further, an optical sensor may be used to determine a water level. The electrical energy extraction device 103 may be activated by the controller 100 when the sensor indicates that the predetermined water level has been reached.

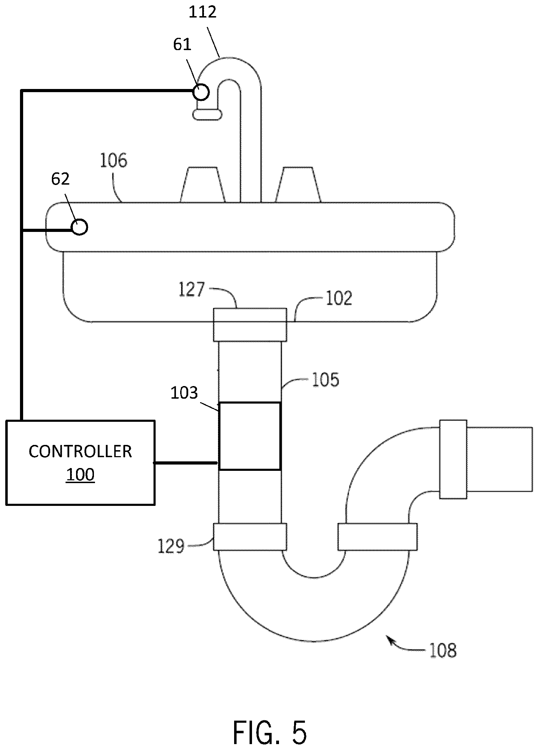

FIG. 5 illustrates an example lavatory or sink 106 and faucet 112 connected to an electrical energy extraction device 103 (thermoelectric cell). The sink 106 may be connected to a plumbing system (e.g., including hose or pipe 105) connected to the electrical energy extraction device 103. The pipe 105 receives waste water, which may have a high temperature through the drain 127 coupled to the bottom 102 of the sink 106. The electrical energy extraction device 103 may extend from the drain 127 to a coupling with trap 108. That is the electrical energy extraction device 103 connect to the drain 127 and to trap 108 such that the electrical energy extraction device 103 is a standalone plumbing fixture that can be added to any lavatory. Additional, fewer or different components may be included.

The sink 106 may include a faucet electrical component 61 and/or a lavatory electrical component 62 that receives electrical power from the electrical energy extraction device 103 as regulated by the controller 100.

The faucet electrical component 61 may include a proximity sensor or gesture sensor configured to detect movement of a user to turn on or off the faucet 112, or provide another selection (e.g., temperature) to the faucet 112. The faucet electrical component 61 may include an indicator (e.g., LED) that indicates whether the faucet is on or off (e.g., valve is open or closed). Alternatively, or in addition, the indicator may represent a temperature of the water (e.g., a degree to which a hot valve is open or closed).

Similarly, the lavatory electrical component 62 may include a proximity sensor for detecting a user in position to use the sink 106 or a gesture sensor for detecting a command for the faucet. The lavatory electrical component 62 may indicate the temperature of the water for the faucet 112. The lavatory electrical component 62 may indicate whether the sink 106 is clean. The lavatory electrical component 62 may include a misting device, chemical sprayer, or misting device.

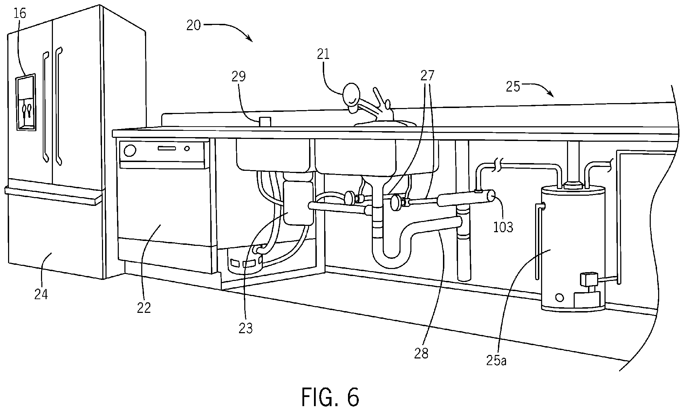

FIG. 6 illustrates example kitchen appliances for use with an electrical energy extraction device 103 that is placed in-line with the plumbing system. The kitchen devices may include one or more of a kitchen faucet 21, a dishwasher 22, a garbage disposal 23, a refrigerator 24, a water heater 25a, and a water filter. The water heater 25 (including tank 25a, water supply 25b, and optionally fuel supply 25c) may provide heated water to the other appliances. Each of the intelligent kitchen devices may be connected to a water supply 27 and a drain 28. The water supply may include the electrical energy extraction device 103. Additional, different, or fewer components may be included.

In one example, all of the water provided from the water heater 25 through water supply 25b passes through the electrical energy extraction device 103. Alternatively, the electrical energy extraction device 103 may be placed on the drain 28 of one or more of the devices such that the energy extraction device 103 extracts energy from the waste water as it leaves the kitchen.

The water supply 25b may include a water filter to filter water before the water is provided to any of the other kitchen devices or to the electrical energy extraction device 103. The water filter may include various settings including filtering modes that target particular contaminants. For example, the water filer may include a lead filtering mode which may target removing lead from the water, a bacteria filtering mode which may target removing bacteria from the water, or specific particulate filtering mode for removing a specific particulate from the water. The refrigerator 24 may include a water dispenser 30. Alternatively, the water dispenser 30 may be a standalone device or another type of beverage dispenser.

A control circuit may receive the output of the electrical energy extraction device 103 and provide the electrical power to one of the kitchen devices. The electrical energy extraction device 103 may power a display. The electrical energy extraction device 103 may power an indicator such as an LED that indicates a status of one of the kitchen devices. A whole kitchen indicator 29 may provide the status of any of the appliances or of the kitchen as a whole. The electrical energy extraction device 103 may provide power to a sensor for monitoring one or more of the kitchen devices. The electrical energy extraction device 103 may include a radio for wireless communication between one of the kitchen devices and a mobile device.

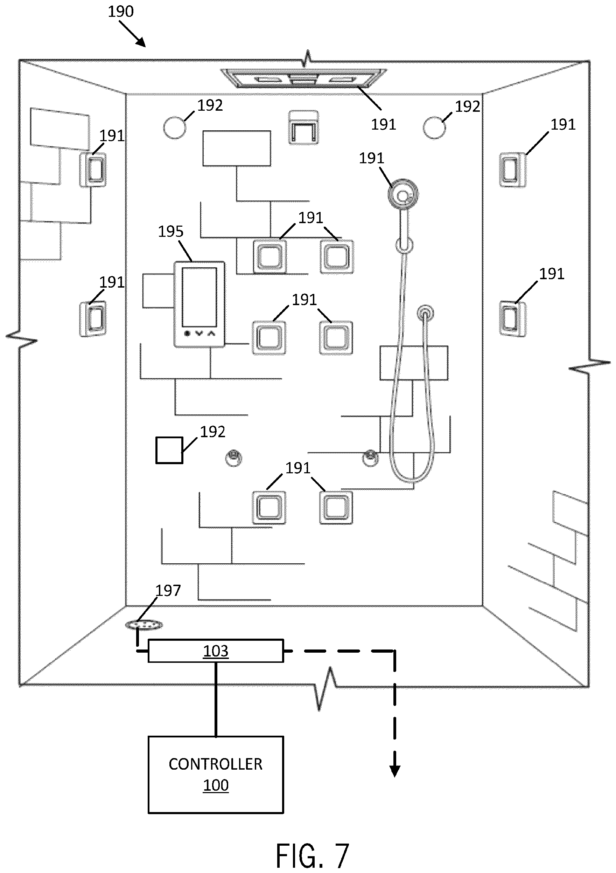

FIG. 7 illustrates example shower appliances for use with an electrical energy extraction device 103. A shower 190 includes a shower enclosure and several shower subsystems (i.e., a water subsystem, an audio subsystem, a steam subsystem, a lighting subsystem, etc.). Each of the shower subsystems has output devices (e.g., shower outlets, flow control valves, temperature control valves, solenoids associated with the valves, lighting devices, audio output systems, steam outlets, etc.) configured to provide a user of the shower with an enhanced showering experience. The shower 190 may include multiple water dispensers 191, sensors 192, and at least one control panel 195. The control panel 195 includes an electronic display. The electronic display is configured to display graphical user interfaces for allowing user control of the various shower subsystems and/or shower output devices.

Shower 190 includes a water subsystem having various output devices (i.e., shower outlets) located within the shower enclosure. For example, shower 190 is shown to include multiple water dispensers 191 including a front showerhead, a left showerhead, a right showerhead, an upper body spray, a middle body spray, a lower body spray, side body sprays, a handshower, and a rainhead. In various embodiments, the water subsystem or set of output devices may include any number or combinations of output devices. For example, in an alternative exemplary embodiment, the water subsystem may include a central body spray (e.g., a vertical column of shower outlets) in place of upper body spray and middle body spray. In another exemplary embodiment, the left showerhead and right showerhead may be located on front wall. Shower outlets may be located on any of surfaces and may include additional or fewer shower outlets in various embodiments.

The electrical energy extraction device 103 may be placed in line with the drain 197 of the shower. Water from any of the output devices is collected at the drain 197 and flows through the electrical energy extraction device 103.

The controller 100 may activate and deactivate the electrical energy extraction device 103 based on operation of the shower 190, a predetermined time schedule, or feedback from one or more sensors 192. The sensor 192 may proximity sensors or motion sensors that determine when a user is present in the shower or the shower is in use.

The electrical energy extraction device 103 may provide electrical power to operate the electronic display of the control panel 195. In various embodiments, the controller 100 may be integrated with the control panel 195, physically separate from the control panel 195, or partially integrated and partially separate from the control panel 195. The control panel 195 may include a touch-sensitive panel overlaying the electronic display (e.g., a capacitive touch screen), manually-operable buttons (e.g., capacitive touch buttons), and/or other user input devices configured to receive user input and provide the user input to the controller 100. The control panel 195 (e.g., via the controller) controls the various components of the shower in response to the user inputs (e.g., signals or data representing the user inputs) received at the user input devices.

In some embodiments, the control panel 195 is configured to receive user inputs for controlling the shower subsystems and for communicating settings and status information of the shower subsystems to a user. Control panel 195 generally includes a housing and an electronic display (e.g., an LCD panel). The housing includes various attachment points (e.g., brackets, fasteners, portions for receiving screw heads, etc.) for mounting control panel 195 within shower enclosure. The housing also provides a waterproof casing to protect electronic display and associated internal electronic components from moisture. A touch-sensitive panel (e.g., a capacitive touch panel) may also be provided on the housing for receiving user inputs. A portion of the touch-sensitive panel may overlay electronic display to provide a touchscreen interface. The electronic display can be caused to display graphical user interfaces and to receive user inputs via the touch screen interface.

In addition or alternatively to the display and control panel 195, the electrical energy extraction device 103 may provide electrical power to one or more LEDs that indicate the status and operation of the shower.

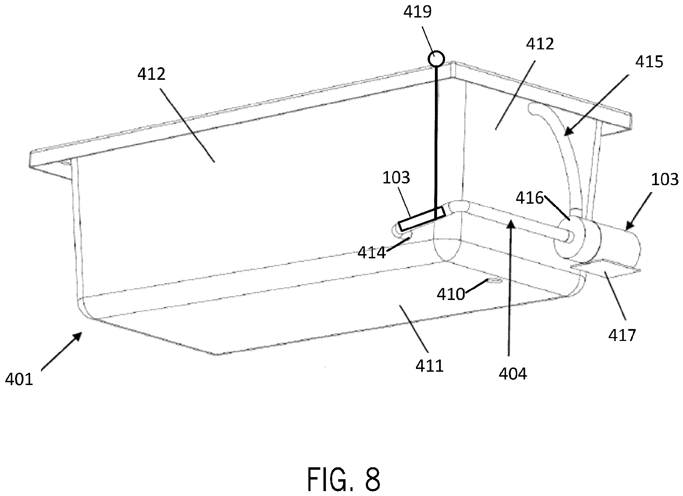

FIG. 8 illustrates an example bathtub 401 for use with electrical energy extraction device 103. The bathtub 401 includes a body 412 configured to hold water and a base 411 configured to support the body 412 and including a main drain 410. The body 412 may also include a side drain 414 that connects a supply pipe 404 to the electrical energy extraction device 103. A pump 416 may recirculate water through the side drain 414 through the supply pipe 404 to the electrical energy extraction device 103. The electrical energy extraction device 103 may generate electrical power according to any of the embodiments herein and provide electrical power to an indicator 419. The indicator 419 may include an LED or display for providing a status of the bathtub 401 or one or more related systems.

The electrical energy extraction device 103 may be placed on the drain, body 412 or another location of a bathtub 401 that does not recirculate or include any pump 416.

In another example, not pictured, the electrical energy extraction device 103 may be provided to a main supply line of a bathtub. That is, the electrical energy extraction device 103 may be coupled between a water line supply and the faucet of the bathtub 401.

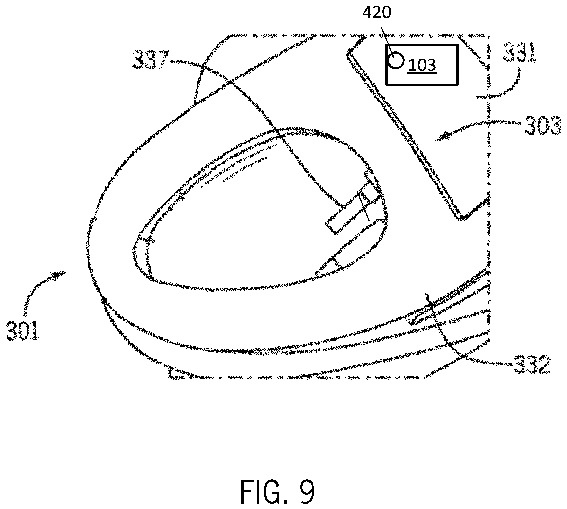

FIG. 9 illustrates an example bidet wand 337 for use with an electrical energy extraction device 103. The bidet wand 337 may be integrated with a toilet 301 or a toilet seat assembly 332. The electrical energy extraction device 103 may be located in a cavity 303 and may be accessible via a cover 331. A reservoir tank may supply the bidet wand 337 or a tubing that supplies the bidet wand 337 with warm water. After use of the bidet wand 337, the excess water in the reservoir tank may provide a temperature gradient to the electrical energy extraction device 103. In addition or in the alternative, a front wash bidet may be positioned near the front of the toilet for female users and implemented with a similar type of energy extraction device 103.

The electrical energy extraction device 103 may generate electrical power according to any of the embodiments herein and provide electrical power to an indicator 420. The indicator 420 may include an LED or display for providing a status of the bidet or one or more related systems.

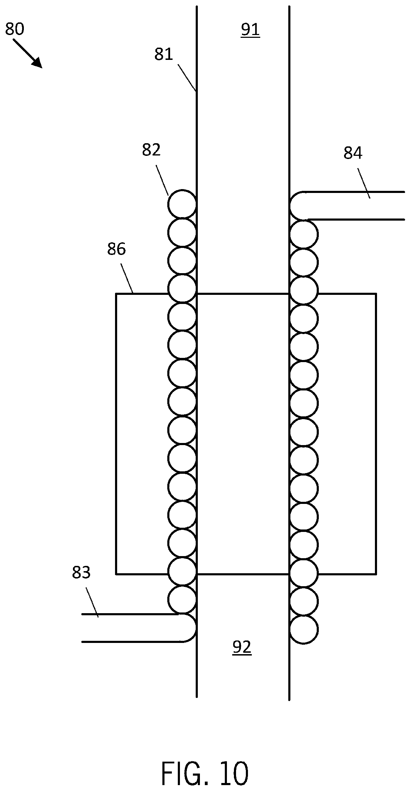

FIG. 10 illustrates an example thermal recovery device 80. The thermal recovery device 80 may include at least one thermal radiation device, an appliance facing connection, coupling, or pipe (first connection) 84, and a supply facing connection, coupling, or pipe (second connection) 83. Additional, different, or fewer components may be included.

The thermal recovery device 80 may be thermally connected or adjacent to a waste water pipe 91. The waste water pipe 91 may carry exhaust water from one or more water consuming appliances. The waste water pipe 91 may empty to a sanitary path 92 such as a sewer pipe, sewage system, or septic system.

In some examples the thermal recovery device 80 is a coil of pipes 82 that wrap around the waste water pipe 91. The coil of pipes 82 connects the appliance facing connection 84 and the supply facing connection 83. Water from the water supply flows through the supply facing connection 83, through the coil of pipes 82, and into the appliance facing connection 84 where it is supplied through the plumbing system to one or more water consuming appliances. The coils of pipes 82 may extend along the circumference of the waste water pipe 91 multiple times. Examples include 3-20 wraps of the pipes 82 around the waste water pipe 91. The pipes 82 may contact the waste water pipe 91 directly. The pipes 82 may be separated from the waste water pipe 91 by a thermally conductive adhesive, paste, or fluid. Heat is transferred from the waste water pipe 91 to the pipes 82 heating the water therein based on thermal transfer. Heat absorbed into the water supply conserve the energy that is required to later heat the water (e.g., at a water heater). Countercurrent flows may provide the highest efficiencies.

In some examples the thermal recovery device 80 additionally or alternatively includes a radiator 86. The radiator 86 may include one or more chambers configured to contain fluid and release heat from the fluid into the ambient air. The radiator 86 may include one or more chambers configured to contain air or other gases and release heat from the fluid into the ambient air. In some examples, the pipes 82 pass through the radiator 86 to provide the heat exchange. In some examples, the radiator 86 directly radiates heat from the waste water pipe 91. In some examples, both paths for heat exchange occur. In some examples, the pipes 82 are omitted.

The thermal recovery device 80 radiates heat from the waste water pipe 91 to the ambient air. In this way, heat from exhausted water is utilized for heating the home or building. The thermal recovery device 80 may be placed in a specific room. One example is a basement but any room is possible.

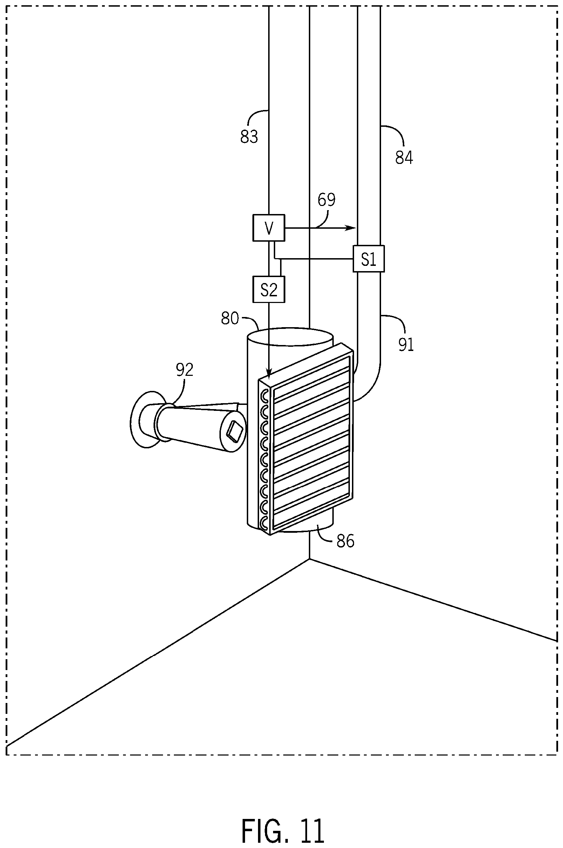

FIG. 11 illustrates an example thermal recovery system including a thermal recovery device 80 in a basement where both the waste water pipe 91 and the supply line (including supply facing connection 83 and appliance facing connection 84) is routed to the basement to absorb heat through the thermal recovery device 80 and the waste water.

In the example of FIG. 11, a bypass path 69 serves to connect the supply facing connection of the supply line and the appliance facing connection 84 of the supply line to bypass the thermal recovery device 80. The bypass path 69 includes a pipe, hose, or other water passage. When valve V is opened, the water supply follows the bypass path 69. When the valve V is closed, the water supply is provided to the thermal recovery device 80 to receive thermal transfer of energy from the waste water pipe 91. In some examples, the bypass path 69 bypass only a radiator 86. In some examples, the bypass path 69 is used to select one of multiple paths through the thermal recovery device 80.

The valve V may be operated manually using a lever. The valve V may be operated electronically and/or automatically using a solenoid of other driving mechanism under the command of controller 100. The controller 100 may operate the valve V for the bypass path in response to sensor data.

In one example, the controller 100 receives sensor data from a waste water side sensor S1 and/or a water supply side sensor S2. Thus, in some examples the temperature sensor is upstream of the radiator in either or both of the waste water pipe 81 and the water supply path 82. In other examples, the temperature sensor may be downstream of the radiator or both upstream and downstream of the radiator.

The controller 100 may open the valve V when the waste water side sensor S 1 indicates the waste water is above a predetermined temperature. The controller 100 may open the valve V when the water supply side sensor S2 indicates that the water supply is below a certain temperature. In other examples, the controller 100 may determine a difference between the values from the waste water side sensor S 1 and the values from the water supply side sensor S2. The controller 100 may open the valve V to activate the bypass path 69 when the difference between the values from the waste water side sensor S 1 and the values from the water supply side sensor S2 is below a predetermined threshold. In other words, when the water supply and waste water are too close in temperature, the thermal recovery device 80 is bypassed.

In one example, the waste water side sensor S 1 and the values from the water supply side sensor S2 relate to flow sensors. In this example, the controller 100 may determine whether the water supply and/or the waste water pipe 91 are active (i.e., having a substantial flow, a nonzero flow, or a flow over a predetermined minimum flow rate). The thermal recovery device 80 is used (bypass path 69 not opened) when one or both of the flow rates are above the predetermined minimum flow rate. In other words, when the water supply and/or waste water are not in operation, the thermal recovery device 80 is bypassed.

The system including the controller 100, the waste water side sensor S 1, the water supply side sensor S2 and the thermal recovery device 80 performs a technique to perform waste water heat recover. First, the thermal recovery device 80 provides a thermal connection between the waste water plumbing fixture 81 configured to receive waste water from at least one water consuming appliance and for a water supply pipe 82 configured to at least indirectly supply water to the at least one water consuming appliance. The controller 100 receives sensor data for the waste water plumbing fixture 81 and the water supply pipe 82. The controller 100 is configured to actuate valve V to open or close the bypass path 69 across the thermal connection in response to the sensor data.

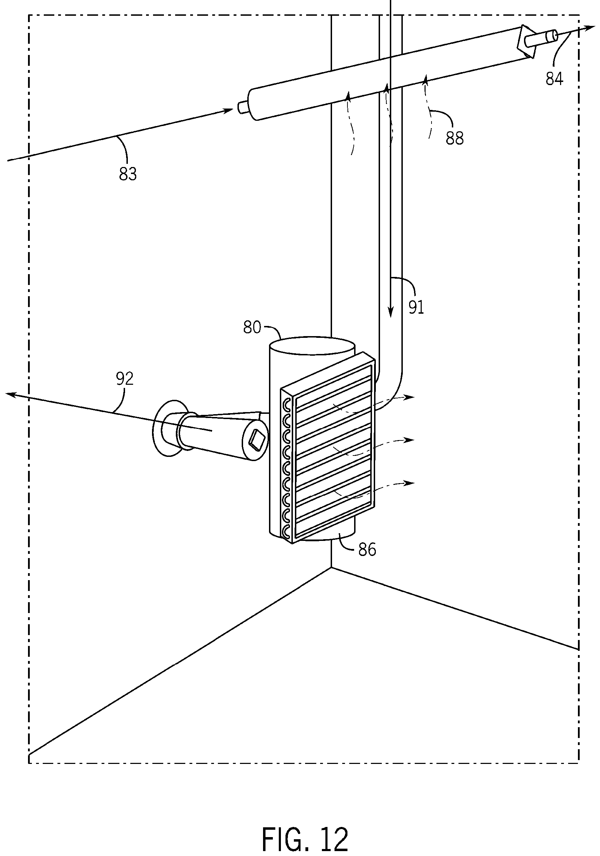

FIG. 12 illustrates an example thermal recovery system in which the thermal recovery device 80 is spaced apart from a supply line (including supply facing connection 83 and appliance facing connection 84). In this case waste water is provided to the thermal recovery device 80 from waste water pipe 91 and then proceeds to a sanitary path 92. Heat is recovered by the thermal recovery device 80 and/or radiator 86 to release heat into the room. The heat may also radiate to the supply line, which partially heats the supply of water into the house or building. The at least one thermal radiation device is configured to heat the water pipe spaced apart from the waste water heat recovery device 80.

In one example, the water supply enters the building at a first temperature (e.g., 41 degrees Fahrenheit) and is raised to a second temperature (e.g., 60 degrees Fahrenheit) through the use of the thermal recovery device 80. Specifically, the thermal recovery device 80 may receive waste water from waste water pipe 91 at a third temperature (e.g., 95 degrees Fahrenheit) and release heat into the room that also heats the supply line (as shown by arrows 88).

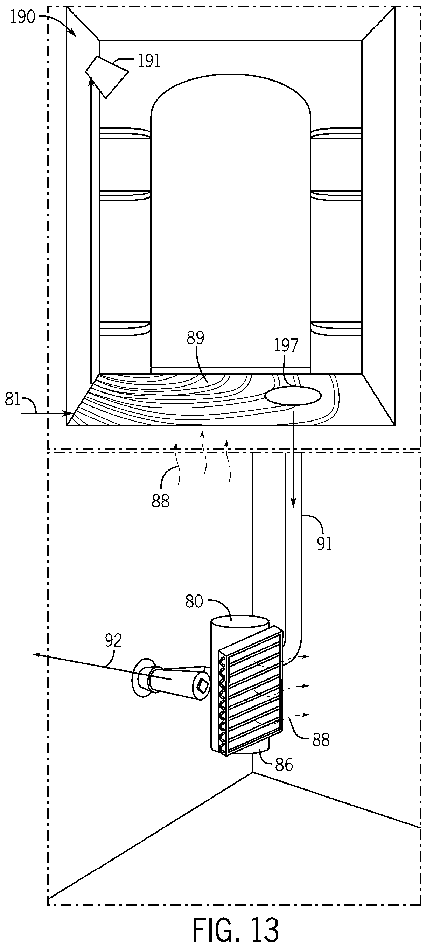

FIG. 13 illustrates an example thermal recovery system where the thermal recovery device 80 is placed in proximity to a shower 190. The thermal recovery device 80 may be placed in an adjacent room or a floor below the shower 190. Heat that radiates (as shown by arrows 88) from the thermal recovery device 80 and/or radiator 86 provides head to a shower receptor 89. The shower receptor may be a tray or surface in the floor of the shower 190. Water spent at the shower 190 may be provided through the drain 197 into the waste water pipe 91. Heat from the water radiates from the thermal recovery device 80 back to the shower receptor 89, heating the floor of the shower 190. At the same time or alternatively, the head may be provided to the water entering the shower at the supply 81. Additional, different, or fewer components may be included.

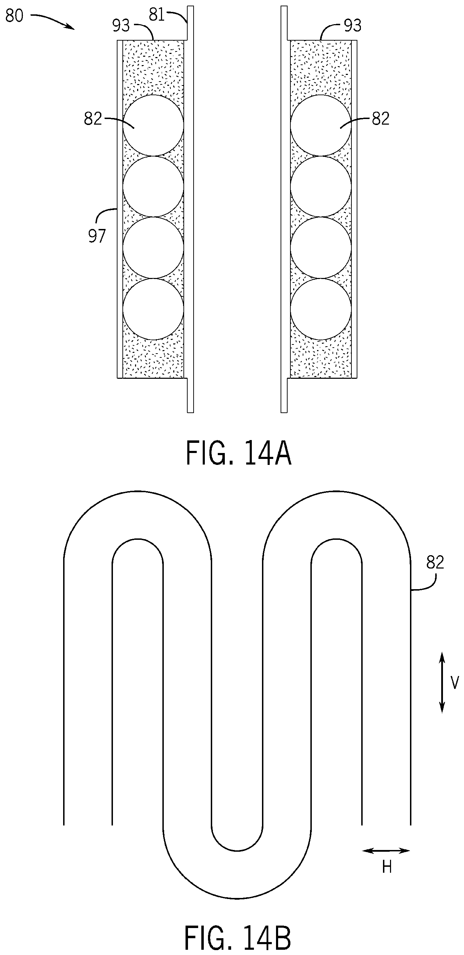

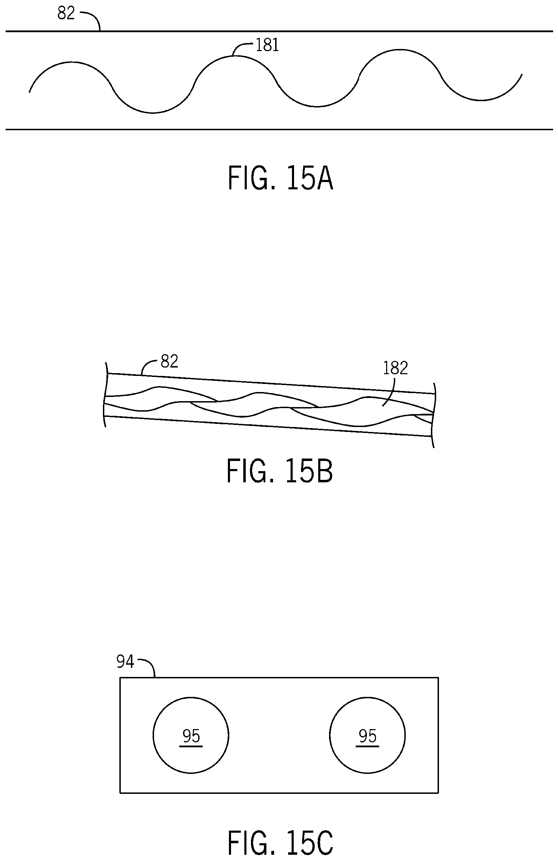

FIGS. 14A-C and 15A-C illustrate example embodiments for a path of the water supply pipes 82 and a pipe of the waste water pipe 81 through the thermal recovery device 80. The water supply pipes 82 may take a variety of forms including a pipe pattern where the flow of water is in multiple directions. The pipe pattern configured to improve transfer of heat from the waste water to the water of the first pipe. The pipe pattern may include a serpentine path for the shape of the first pipe, a longitudinal wave pattern in a flow direction of the first pipe, or a turbulator. The pipe pattern may be internal to the water supply pipes 82. Additional, different, or fewer components may be included.

In FIG. 14A, a chamber 97 is coupled to the waste water pipe 81. The waste water pipe 81 may support the chamber 97. The chamber 97 may support the water supply pipe 82. The chamber includes a thermally conductive fluid 93. It is often difficult or expensive to provide a tight thermal connection between the inner and outer walls of the two pipe. A thermally conductive fluid can fill in these unintended gaps. The thermally conductive fluid 93 improves the thermal transfer between water supply pipes 82 and the waste water pipe 81. The thermally conductive fluid 93 may be an interstitial fluid 93

Examples for the thermally conductive fluid 93 include ethylene-glycol, propylene glycol, silicone oil, and water. Heat transfer fluids may be chosen based upon their high heat capacities, viscosities, boiling points, and corrosion resistances.

The chamber 97 may be adjacent to the at least one thermal radiation device. The thermal radiation device may be the waste water pipe 81. The thermal radiation device may be the radiator 86. The chamber 97 may be secured to the at least one thermal radiation device using a fastener such as a clamp.

FIG. 14B illustrates another example plumbing fixture 82 for the thermal recovery device. In this example, the plumbing fixture 82 includes a serpentine path. The serpentine path may be applied to the water supply pipes 81 around the circumference of the waste water pipe 81. The serpentine path may extend in a first direction and a second direction substantially perpendicular to the first direction. The radiator 86 may also include pipes or chambers having a serpentine path.

FIG. 15A illustrates another example plumbing fixture 82 for the thermal recovery device including a wave shape structure 181. The wave shape structure 181 may include an internal wave of plastic or metal. The wave shape structure 181 disrupts the path of the water through the plumbing fixture 82. The wave shape structure 181 may cause a laminar flow through the plumbing fixture 82 to become a turbulent flow. Turbulent flows have thinner thermal boundary layers at the wall, and therefore greater heat transfer coefficients. The water is circulated or otherwise flows in an indirect problem to increase the thermal transfer from the plumbing fixture 82 to the water. Alternatively or additionally, a similar wave shape structure 181 may be mounted inside the waste water pipe 81 to increase the thermal transfer from the waste water to the waste water pipe 81.

FIG. 15B illustrates another example plumbing fixture 82 for the thermal recovery device 80 including a turbulator 182. The turbulator 182 may have a helical shape. The turbulator 182 may have a double helix shape. The turbulator 182 may cause a laminar flow through the plumbing fixture 82 to become a turbulent flow. The turbulator 182 may have a twisted tape shape.

The water is circulated or otherwise flows in an indirect problem to increase the thermal transfer from the plumbing fixture 82 to the water. Alternatively or additionally, a similar wave shape structure 181 may be mounted inside the waste water pipe 81 to increase the thermal transfer from the waste water to the waste water pipe 81.

FIG. 15C illustrates another example fixture 94 for the thermal recovery device 80. The fixture 94 may be a plate made of a material having a high thermal conductivity. The fixture 94 may be a flat panel heat exchanger. Multiple coils of the water supply pipe 82 may be mounted on the fixture 94. The fixture 94 may also be in contact with the waste water pipe 81. The fixture may also provide a thermal path between multiple coils of the water supply pipe 82 and the waste water pipe 81.

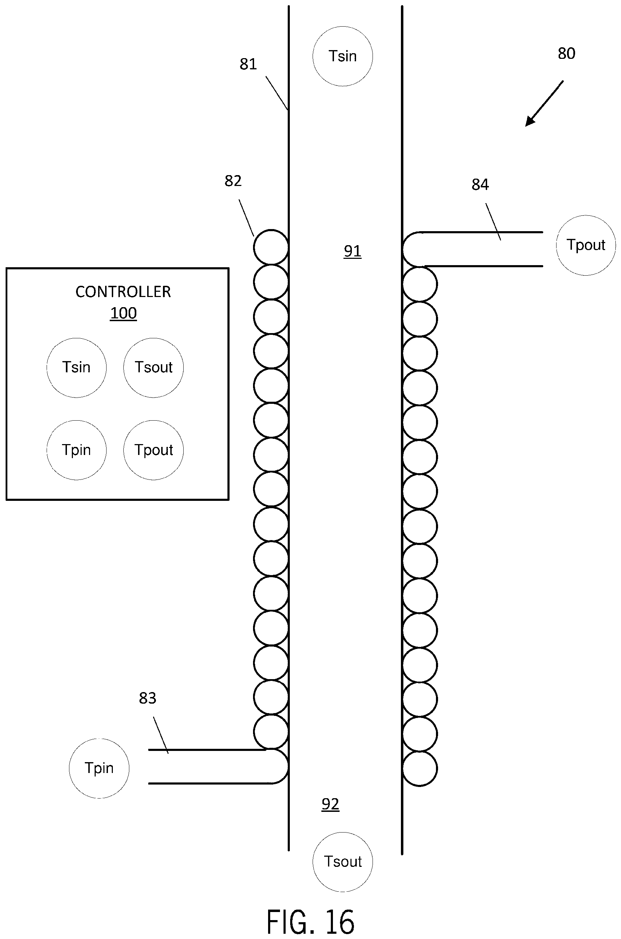

FIG. 16 illustrates an alert system for a thermal recovery device 80. Fouling is a problem that can affect the operation of the thermal recovery device 80 such as the efficiency of the heat exchange. When surfaces are dirty, they transfer heat less efficiently. Fouling may be combatted in several ways internally. Some treatments include ultraviolet (UV) lamps, coatings on the internal walls of the pipe, or disinfection distribution systems (misting vapors, dispensing ozone, dispensing nanobubbles, dispensing solid or liquid chemicals) for the walls.

One example of dispending solid or liquid chemicals includes phosphate beads. The phosphates beads may be stored in a sieve or cage within the thermal recovery device 80. As water flows through the sieve or cage, contact with the phosphate beads causes the beads to slowly dissolve. The dissolving beads alter the interaction of the water with one or more mineral (e.g., iron, calcium, etc.) to reduce scaling on the internal surfaces of the thermal recovery device 80.

Feedback systems including temperature sensors may also monitor fouling or other conditions that cause the efficiency of the thermal recovery device 80 to deteriorate. One or more of the treatments may be applied in response to the monitored conditions of the thermal recovery device 80. Additional, different, or fewer components may be included.

As in other embodiments, a waste water pipe 81 is thermally connected to water supply coils 82. Thermal energy such as heat is transferred from the waste water pipe 81 to the water supply coils 82. A controller 100 is connected to one or more temperature sensors for monitoring the waste water heat recovery apparatus 80.

The alert system may include two or more sensors associated with the waste water heat recovery apparatus. The alert system may include at least one septic side temperature sensor configured to measure a temperature of a waste water plumbing fixture and at least one potable side temperature sensor configured to measure a temperature of a water supply pipe. Each of the sensors generate sensor data that describes the temperature of the specific portions of the waste water recovery apparatus. The at least one septic side temperature sensor measures a temperature associated with the waste water pipe 81. The at least one potable side temperature sensor measures a temperature associate with the water supply coils 82.

In one example, the controller 100 identifies a baseline performance (or initial performance) over a set time period (or baseline period) using the data measured by the temperature sensors. Subsequent measurements by the temperature sensors for an ongoing performance are compared to the baseline performance. When the performance drops below a particular level, the controller 100 generates an alert.

More specifically, the controller 100 calculates a baseline value or values for the waste water recovery apparatus 80. The baseline values may be based on a ratio of the temperature change in the water supply pipe 82 (potable side) to the temperature change in the waste water pipe 81 (septic side). The at least one potable side temperature sensor includes an input side sensor $T_{pin}$ for the water supply pipe 82 and an output side sensor $T_{pout}$ for the water supply pipe 82. The temperature change in the water supply pipe 82 may be the difference $T_{pout} - T_{pin}$. The at least one septic side temperature sensor includes an input side sensor $T_{sin}$ for the waste water plumbing fixture 81 and an output side sensor $T_{sout}$

for the waste water plumbing fixture 81. The temperature change in the waste water pipe 81 may be the difference between Tsin - Tsout.

When the ratio is lower (e.g., the ratio goes down over time) it is an indication that less thermal transfer is occurring in the waste water recovery apparatus 80. In other words, the system is becoming less efficient, which may be an indication of fouling or other build up inside the waste water recovery apparatus 80.

As shown by Equation 1, a ratio of the temperature change delta T ($\Delta T$) to heat explains the thermal efficiency of the system. The ongoing performance, at any time t, is represented by the ratio of the temperature change to heat. The baseline performance is the ratio of the initial temperature value and heat value. When the system is performing at maximum efficiency (e.g., the efficiency of the baseline), the value for Rf(t)=0. In other words, the function Rf is the thermal resistance due to fouling and Rf(0) is initially 0 because there is initially no fouling in the system. X is a chosen value or threshold at which fouling is significant enough to warrant cleaning. X is positive. X may be a critical value for R ($R_{crit}$) at which the waste water recovery apparatus 80 is operation at a designated efficiency or other minimum level.

$$R_f(t) = \frac{\Delta T(t)}{q(t)} - \frac{\Delta T_0}{q_0} > R_{crit} \qquad \text{Eq. 1}$$

Because q (heat rate) cannot be directly measured, temperatures at the inputs and outputs of the water streams provide an accurate estimation of the heat rate q. Multiple values are measured from the temperature sensors and the controller monitors the performance of the waste water recovery apparatus 80 over time. For example, the ongoing ratio may be calculated as a function of time as shown by Equation 2 below. The ratio of the temperature change in the water supply pipe 82 over the temperature change in the waste water pipe 81 is shown by $\frac{TP_{out}(t) - TP_{in}(t)}{TS_{in}(t) - TS_{out}(t)}$. Similarly the baseline value at t=0 is calculated as $\frac{TP_{out\_0} - TP_{in\_0}}{TS_{in\_0} - TS_{out-0}}$.

$$\frac{TP_{out}(t) - TP_{in}(t)}{TS_{in}(t) - TS_{out}(t)} - \frac{TP_{out\_0} - TP_{in\_0}}{TS_{in\_0} - TS_{out-0}} > X \qquad \text{Eq. 2}$$

The controller 100 determines when the ongoing ratio or the ratio of the temperature change in the water supply pipe 82 over the temperature change in the waste water pipe 81. The controller 100 determines when a difference between the ongoing ratio and baseline ratio exceeds threshold X.

The controller 100 is configured to generate an alert message when the difference between the ongoing ratio and baseline ratio exceeds threshold X. Thus, the controller 100 generates the alert message based on the temperature of the waste water plumbing fixture and the temperature of the water supply pipe.

The alert message may be an alphanumeric word or code for the user or maintenance technician. The alphanumeric word or code may be presented on a display. The display is configured to display the alert message including an indication of potential failure of the waste water heat recovery apparatus. The message for the user may indicate that the thermal recovery device 80 needs cleaning. The message for the user may prompt the user to activate a cleaning cycle. The message for the user may include an efficiency value or percentage that demonstrates a level of efficiency that the thermal recovery device 80 is operating. The message for the user may instruct the user to call or request for maintenance.

The alert message may include one or more communication packets for network transmission of data related to the thermal recovery device 80. The thermal recovery device 80 may include or otherwise be connected to a communication interface configured to transmit the alert message over a network. The thermal recovery device 80 may be wirelessly connected or hardwired to a network such that the thermal recovery device 80 communicates with one or more external devices.

One example external device includes a central control device. The central control device may be associated with a manufacturer of the thermal recovery device 80 or a maintenance entity for the thermal recovery device 80. The thermal recovery device 80 may sent measurements through the central control device. The central control device may return commands to the thermal recovery device 80. Example commends may include activation of a cleaning cycle, or any cycle for any of the subsystems below. The alert message may also be sent to the central control device to dispatch maintenance for the thermal recovery device 80.

One example external device is a mobile device. The thermal recovery device 80 may communicate with the mobile device of a user to display the alert message. The user may also initiate a cleaning cycle, or a cycle for any of the subsystems below, from a user input to the mobile device.

The alert message may be an instruction or a command for the waste water recovery system 80 or a subsystem of the waste water recovery system 80.

On example subsystem is a cleaning device. The alert message may include a command for a cleaning device. The cleaning device may include a wiper or scrubbing pad that abrasively contacts the inside of the waste water pipe 81 or the water supply pipe 82.

One example subsystem is a treatment device. The treatment device may include an ultraviolet light configure to treat or otherwise provided ultraviolet light to one or more pipes or chambers of the waste water recovery system 80.

The treatment device may include a cleaning compound dispenser. The treatment device may mix a chemical solution including one or more of hydrogen peroxide, hypochlorous acid, iodine, bromine, chloramine, chlorine dioxide, peracetic acid, quaternary ammonium, tetraacetyl ethylenediamine, phenolic, isopropyl alcohol, sodium carbonate, peroxyhydrate, tetraacetyl ethylenediamine, ethanol, sodium hypochlorite, octanoic acid, or sodium chlorite. The treatment device may mix water from a water source with a solid compound. The water may be sourced by the water supply pipe 82 or the waste water pipe 81. The water may be sourced separately (water line input to the treatment device). The treatment device may dispense the cleaning solution on the internal walls of the water supply pipe 82 or the waste water pipe 81 in order to reduce fouling and improve the efficiency of the thermal recovery device 80.

The treatment device may include a nanobubble generator. The controller 100 may generate a command for the cleaning device that activates a nanobubble generator. The nanobubble generator may also generate microbubbles and the combination of microbubbles and nanobubbles (MNBs) in water consuming devices and plumbing fixtures may be at a variety of proportions. The term nanobubbles may be used to describe bubbles having a diameter of up to approximately 1 micrometer ($\mu$m). The term microbubbles may be used to describe bubbles with diameters approximately from 1 to 100 $\mu$m. Additional bubbles may be present when MNBs are generated such as bubbles with diameters from 100 to 1000 $\mu$m or larger. Microbubbles are visible to the human eye. Nanobubbles are not visible to the unaided human eye.

Some generation processes may be directed at nanobubbles primarily while others may be directed at microbubbles primarily. Some generation processes may produce bubbles of ozone (trioxide or $O_3$) hydrogen gas, carbon dioxide gas, or bubbles of air, which may include various constituents or molecules such as nitrogen, oxygen, argon, carbon dioxide and other gases. Ozonated water is a powerful disinfectant that can be generated on-site at a particular device. On-site generation has advantages. One advantage is that there are no consumable chemicals required. One problem is that ozone has a slow and limited solubility in water. As such, ozone gas likely escapes from the water surface and into the environment.

The treatment device may use a variety of techniques produce MNBs. In one example, an air stream under pressure is dissolved into liquid with a nozzle to generate bubbles under the cavitation principle. The nozzle may be a venturi tube. In cavitation the static pressure of a liquid is below the liquid's vapor pressure, causing vapor filled cavities to form. The vapor pressure is the pressured in thermodynamic equilibrium with the other phases (liquid and solid) at a specific temperature. In another example, MNBs are formed from ultrasound to induce cavitation in the liquid. In another example, MNBs are formed through a shearing force. The air stream is provided under low pressure and bubbles are broken off into the liquid using the shearing force. The shearing force may be a vibration, provided from fluidic oscillation, or other methods. A venturi may merge a flow of water and a flow of air. The flow of the water at the venturi creates the shearing force for formation of the MNBs. The shearing force and the size of the MNBs (e.g., the distribution of various sizes of bubbles) may be adjusted based on the shape of the water and air passage passages, the quantity of the passages, and other features. Besides air, ozone, other gases, or other compounds may be provided at the opening of the venturi. Additional, different, or fewer components may be included.

The treatment device may include an ozone generator. The controller 100 may generate a command for cleaning device activates an ozone generator. Ozone may be formed by the treatment using a variety of techniques, including corona discharge, ultraviolet light, cold plasma, and other techniques. For example, a corona charger may be configured to accumulate electric charge from the power source and apply the electric charge to air from the air source.

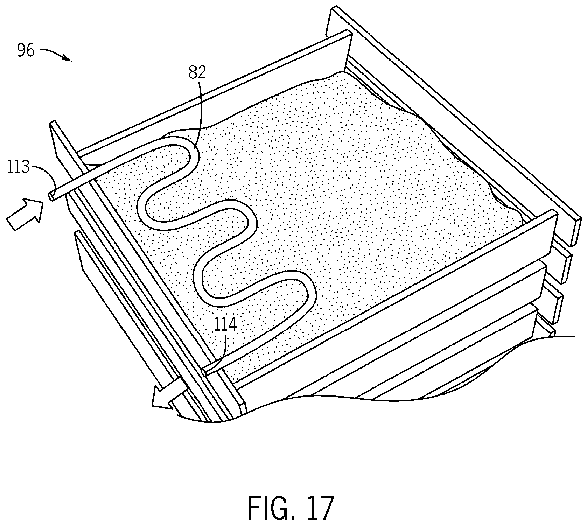

FIG. 17 illustrates an example thermal recovery device for a compost system. The compost system may include a compost bin 96 and one or more water supply pipes 82 passing through the compost bin 96. The water supply pipe 82 includes a first connection 113 coupled to the pipe and a water supply and a second connection 114 coupled to the pipe and at least one water consuming appliance. The compost bin 96 includes organic material (e.g., food scrap, leaves, yard waste, manure etc.). The organic material decomposes in the compost bin 96 into soil.

Microorganisms such as bacteria and fungi break down the organic matter in the compost pile. As the microorganisms consume the organic material, energy in the form of heat is released. Thus, the compost bin 96 generates heat that is applied to the water supply pipe 82 and increases the temperature of the water in the water supply pipe 92. Increasing the temperature of the water in the water supply pipe 82 results in less energy being consumed at a water heater or other downstream appliance.

The water supply pipe 82 in the compost bin 96 may include any of the water turbulence devices described herein including the wave shape structure 181 ot the turbulator 182. The water supply pipe 82 may include fixture 94 as a plate with high thermal conductivity that supports one or more serpentine paths of the water supply pipe 82. The water supply pipe 82 in the compost bin 96 may include any of anti-fouling devices described herein including an ultraviolet light, cleaning compound dispenser, ozone generator, or MNB generator.

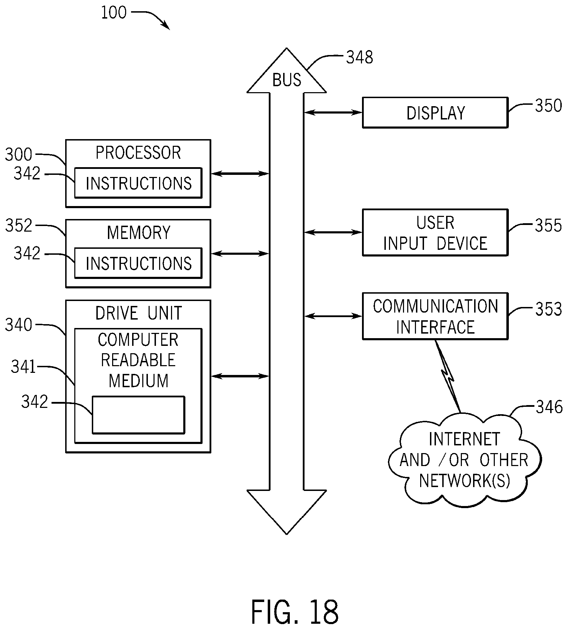

FIG. 18 illustrates an example controller or control system 100 for any off the heat recovery systems and associated subsystems. The controller 100 may include a processor 300, a memory 352, and a communication interface 353 for interfacing with devices or to the internet and/or other networks 346. In addition to the communication interface 353, a sensor interface may be configured to receive data from the sensors described herein or data from any source for analyzing air or water properties or the operation of the appliances described herein. The components of the control system 400 may communicate using bus 348. The control system 100 may be connected to a workstation or another external device (e.g., control panel) and/or a database for receiving user inputs, system characteristics, and any of the values described herein.

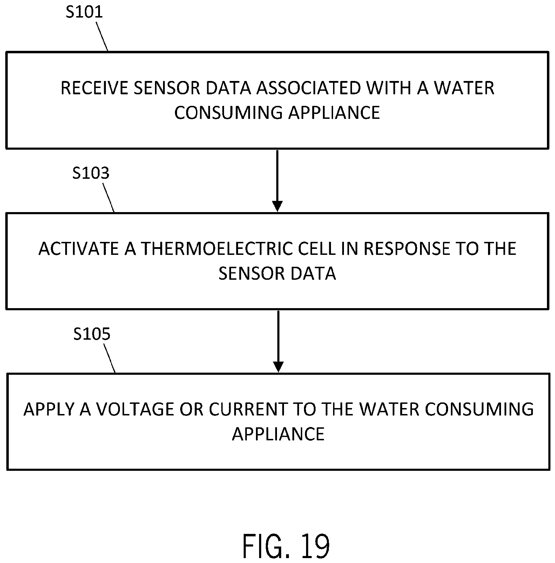

FIG. 19 illustrates an example flow chart for the controller of FIG. 18. Additional, different, or fewer acts may be included.

At act S101, the controller 100 (e.g., processor 300) receives sensor data associated with a water consuming appliance. The sensor data may describe an operation of the water consuming device such as a running time, a selected mode or cycle, temperature detected, or a specific electronic component that is in use. Any of these examples may describe the availability of thermal energy at, downstream, or upstream of the water consuming appliance. The running time may describe the usage of the water consuming appliance such as whether or how much water is being provide to the system. The selected mode or cycle may also describe whether or how much water is being provide to the system as well at the temperature expected for the water. The temperature of the water may be directly detected by a temperature sensor. Any of these data values may directly indicate or imply which of the specific electronic component will be in use at the water consuming appliance.

At act S 103, the controller 100 (e.g., processor 300) activates a thermoelectric cell in response to the sensor data. In some examples, the thermoelectric cell is activated only when hot water is available whether or a certain quantity of water is being provided to the system. In some examples, the thermoelectric cell is activated only when specific electronic components are in use that can be powered by the thermoelectric cell. Example electronic components are low power components such as LEDs or some displays.

At act S 105, the thermoelectric cell applies a voltage or corresponding current to an electronic device for the water consuming appliance. The thermoelectric cell generates the electricity in response to the controller 100 activation and provides power to the electronic device through a wired connection.

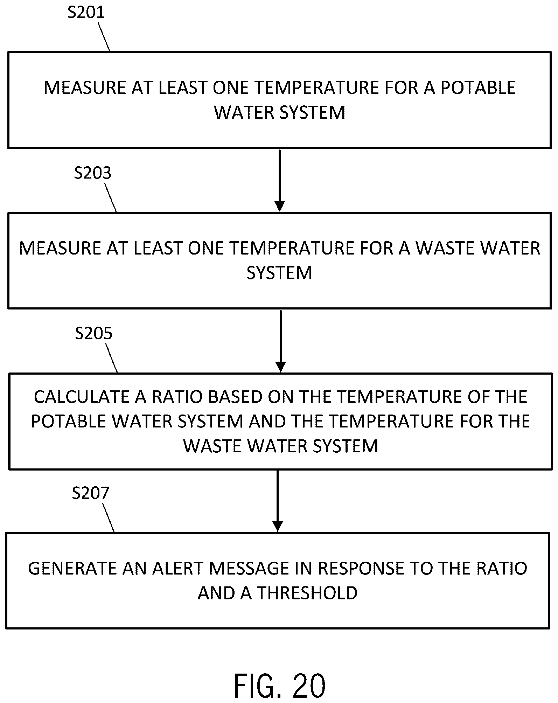

FIG. 20 illustrates an example flow chart for the controller of FIG. 18. Additional, different, or fewer acts may be included.

At act S201, the controller 100 (e.g., processor 300) measures at least one temperature for a potable water system. The temperature may be based on data received from a temperature sensor at a water supply plumbing fixture.

At act S203, the controller 100 (e.g., processor 300) measures at least one temperature for a waste water system. The temperature may be based on data received from a temperature sensor at a waste water plumbing fixture.

At act S205, the controller 100 (e.g., processor 300) may calculate a ratio between the absolute temperatures of the waste water system and the potable water system. Alternatively, the controller 100 (e.g., processor 300) may calculate a ratio between the changes or derivative over time of the temperatures of the waste water system and the potable water system. The inverses of these ratios may be used.

At act S207, controller 100 (e.g., processor 300) may generate an alert message in response to the calculated ratio. When the ratio, exceeds a threshold value, or a difference between the ratio and a baseline exceeds the threshold, the alert message is displayed or sent to an external device.

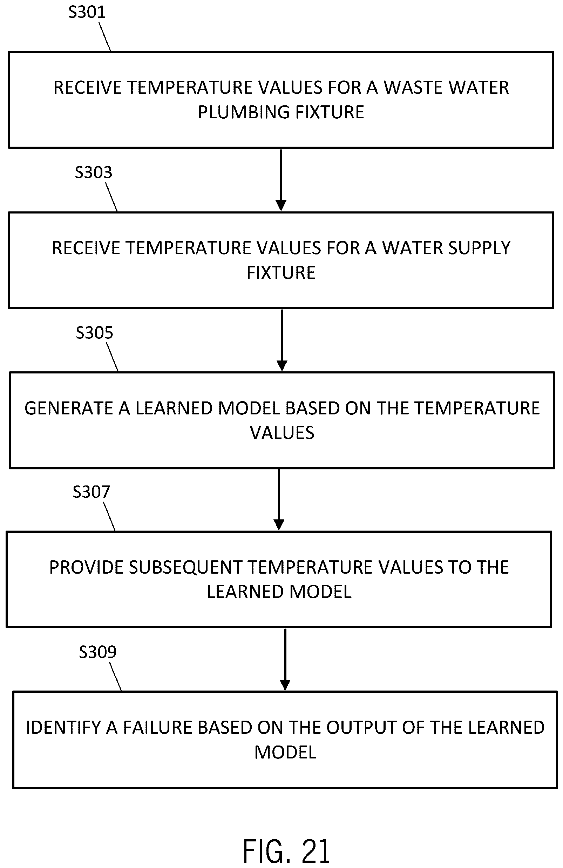

FIG. 21 illustrates an example flow chart for operation of the controller 100 to create and/or implement a learned model to monitor a waste water heat recovery device using the controller 100 of FIG. 18. Additional, different, or fewer acts may be included.

At act S301, controller 100 (e.g., processor 300) receives temperature values for a waste water plumbing fixture from at least one septic side temperature sensor. The septic side temperature sensors include at least one input side value and at least one output side value with respect to the waste water plumbing fixture.

At act S303, controller 100 (e.g., processor 300) receives a second plurality of temperature values for a water supply fixture from at least one potable side temperature. The second plurality of temperature values includes at least one input side value and at least one output side value with respect to the water supply fixture.

At act S305, controller 100 (e.g., processor 300) generates a learned model for prediction of a failure of the waste water heat recovery apparatus based on the first temperature values and the second temperature values. The learned model may be a neural network and the first temperature value and the second temperature values are the ground truth or training data used to define the neural network.

The training data may modify the learned model based on historical usage patterns of the waste water heat recovery apparatus. The usage patterns may depend on the number of people living in a house with the waste water heat recovery apparatus. The usage patterns may depend on particular schedules or user preferences for water temperatures. The historical usage patterns include historic values for the temperature of the waste water plumbing fixture and the temperature of the water supply pipe.

After it is trained, the learned model may include one or more thresholds for current values of the temperature of the waste water plumbing fixture and the temperature of the water supply pipe based on hourly, daily, seasonal, or annual trends.

At act S307, the controller 100 (e.g., processor 300), or another control system, receives subsequent temperatures values from the operation of the waste water heat recovery apparatus.

At act S309, the controller 100 (e.g., processor 300), or another control system, provides the subsequent temperature values to the learned model. The learned model determines whether a failure has occurred. The learned model outputs an indication of the failure based on whether the temperature data indicates that the waste water heat recovery system is operating incorrectly or inefficiently. The learned model may output an alert message as described herein.

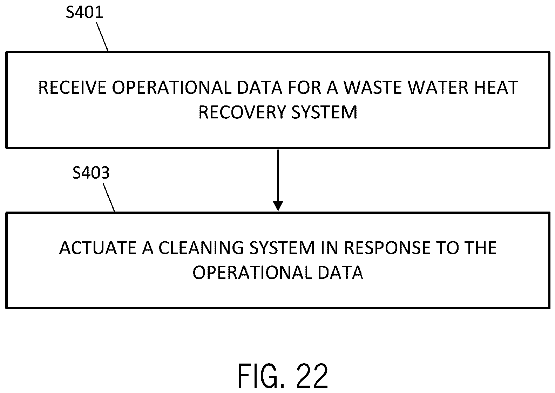

FIG. 22 illustrates an example flow chart for operation of the controller of FIG. 18 in a method for reducing fouling in a waste water heat recover system. Additional, different, or fewer acts may be included.

At act S401, controller 100 (e.g., processor 300) receives operational data for a waste water heat recovery system. The operational data may include a time of use, a schedule, a temperature, a volume, or an image sensor for one or more water passages of the waste water heat recovery system.

At act S403, controller 100 (e.g., processor 300) actuates a cleaning system for in response to the operational data for waste water heat recovery system. Alternatively, the controller 100 may initiate a treatment device in response to the operational data for waste water heat recovery system.

Optionally, the control system 100 may include an input device 355 and/or a sensing circuit in communication with any of the sensors. The sensing circuit receives sensor measurements from as described above. The input device 355 may include a switch (e.g., actuator), a touchscreen coupled to or integrated with, a keyboard, a remote, a microphone for voice inputs, a camera for gesture inputs, and/or another mechanism.

Optionally, the control system 100 may include a drive unit 340 for receiving and reading non-transitory computer media 341 having instructions 342. Additional, different, or fewer components may be included. The processor 300 is configured to perform instructions 342 stored in memory 352 for executing the algorithms described herein. A display 350 may be supported by any of the components described herein. The display 350 may be combined with the user input device 355.

Processor 300 may be a general purpose or specific purpose processor, an application specific integrated circuit (ASIC), one or more programmable logic controllers (PLCs), one or more field programmable gate arrays (FPGAs), a group of processing components, or other suitable processing components. Processor 300 is configured to execute computer code or instructions stored in memory 352 or received from other computer readable media (e.g., embedded flash memory, local hard disk storage, local ROM, network storage, a remote server, etc.). The processor 300 may be a single device or combinations of devices, such as associated with a network, distributed processing, or cloud computing.

Memory 352 may include one or more devices (e.g., memory units, memory devices, storage devices, etc.) for storing data and/or computer code for completing and/or facilitating the various processes described in the present disclosure. Memory 352 may include random access memory (RAM), read-only memory (ROM), hard drive storage, temporary storage, non-volatile memory, flash memory, optical memory, or any other suitable memory for storing software objects and/or computer instructions. Memory 352 may include database components, object code components, script components, or any other type of information structure for supporting the various activities and information structures described in the present disclosure. Memory 352 may be communicably connected to processor 300 via a processing circuit and may include computer code for executing (e.g., by processor 300) one or more processes described herein. For example, memory 298 may include graphics, web pages, HTML files, XML files, script code, shower configuration files, or other resources for use in generating graphical user interfaces for display and/or for use in interpreting user interface inputs to make command, control, or communication decisions.

In addition to ingress ports and egress ports, the communication interface 353 may include any operable connection. An operable connection may be one in which signals, physical communications, and/or logical communications may be sent and/or received. An operable connection may include a physical interface, an electrical interface, and/or a data interface. The communication interface 353 may be connected to a network. The network may include wired networks (e.g., Ethernet), wireless networks, or combinations thereof. The wireless network may be a cellular telephone network, an 802.11, 802.16, 802.20, or WiMax network, a Bluetooth pairing of devices, or a Bluetooth mesh network. Further, the network may be a public network, such as the Internet, a private network, such as an intranet, or combinations thereof, and may utilize a variety of networking protocols now available or later developed including, but not limited to TCP/IP based networking protocols.

While the computer-readable medium (e.g., memory 352) is shown to be a single medium, the term "computer-readable medium" includes a single medium or multiple media, such as a centralized or distributed database, and/or associated caches and servers that store one or more sets of instructions. The term "computer-readable medium" shall also include any medium that is capable of storing, encoding, or carrying a set of instructions for execution by a processor or that cause a computer system to perform any one or more of the methods or operations disclosed herein.

In a particular non-limiting, exemplary embodiment, the computer-readable medium can include a solid-state memory such as a memory card or other package that houses one or more non-volatile read-only memories. Further, the computer-readable medium can be a random access memory or other volatile rewritable memory. Additionally, the computer-readable medium can include a magnetooptical or optical medium, such as a disk or tapes or other storage device to capture carrier wave signals such as a signal communicated over a transmission medium. A digital file attachment to an e-mail or other self-contained information archive or set of archives may be considered a distribution medium that is a tangible storage medium. Accordingly, the disclosure is considered to include any one or more of a computer-readable medium or a distribution medium and other equivalents and successor media, in which data or instructions may be stored. The computer-readable medium may be non-transitory, which includes all tangible computer-readable media.

In an alternative embodiment, dedicated hardware implementations, such as application specific integrated circuits, programmable logic arrays and other hardware devices, can be constructed to implement one or more of the methods described herein. Applications that may include the apparatus and systems of various embodiments can broadly include a variety of electronic and computer systems. One or more embodiments described herein may implement functions using two or more specific interconnected hardware modules or devices with related control and data signals that can be communicated between and through the modules, or as portions of an application-specific integrated circuit. Accordingly, the present system encompasses software, firmware, and hardware implementations.

Herein, the phrase "coupled with" is defined to mean directly connected to or indirectly connected through one or more intermediate components. Such intermediate components may include both hardware and software based components. Further, to clarify the use in the pending claims and to hereby provide notice to the public, the phrases "at least one of <A>, <B>, ... and <N>" or "at least one of <A>, <B>, ... <N>, or combinations thereof' are defined by the Applicant in the broadest sense, superseding any other implied definitions here before or hereinafter unless expressly asserted by the Applicant to the contrary, to mean one or more elements selected from the group comprising A, B, ... and N, that is to say, any combination of one or more of the elements A, B, ... or N including any one element alone or in combination with one or more of the other elements which may also include, in combination, additional elements not listed. Furthermore, to the extent that the term "or" is employed (e.g., <A> or <B>) it is intended to mean "<A> or <B> or both." When the intent is to indicate "only A or B but not both" then the term "only A or B but not both" will be employed.

The illustrations of the embodiments described herein are intended to provide a general understanding of the structure of the various embodiments. The illustrations are not intended to serve as a complete description of all of the elements and features of apparatus and systems that utilize the structures or methods described herein. Many other embodiments may be apparent to those of skill in the art upon reviewing the disclosure.

Other embodiments may be utilized and derived from the disclosure, such that structural and logical substitutions and changes may be made without departing from the scope of the disclosure. Additionally, the illustrations are merely representational and may not be drawn to scale. Certain proportions within the illustrations may be exaggerated, while other proportions may be minimized. Accordingly, the disclosure and the figures are to be regarded as illustrative rather than restrictive.

While this specification contains many specifics, these should not be construed as limitations on the scope of the invention or of what may be claimed, but rather as descriptions of features specific to particular embodiments of the invention. Certain features that are described in this specification in the context of separate embodiments can also be implemented in combination in a single embodiment. Conversely, various features that are described in the context of a single embodiment can also be implemented in multiple embodiments separately or in any suitable sub-combination. Moreover, although features may be described above as acting in certain combinations and even initially claimed as such, one or more features from a claimed combination can in some cases be excised from the combination, and the claimed combination may be directed to a sub-combination or variation of a sub-combination.

One or more embodiments of the disclosure may be referred to herein, individually and/or collectively, by the term "invention" merely for convenience and without intending to voluntarily limit the scope of this application to any particular invention or inventive concept. Moreover, although specific embodiments have been illustrated and described herein, it should be appreciated that any subsequent arrangement designed to achieve the same or similar purpose may be substituted for the specific embodiments shown. This disclosure is intended to cover any and all subsequent adaptations or variations of various embodiments. Combinations of the above embodiments, and other embodiments not specifically described herein, will be apparent to those of skill in the art upon reviewing the description.

It is intended that the foregoing detailed description be regarded as illustrative rather than limiting and that it is understood that the following claims including all equivalents are intended to define the scope of the invention. The claims should not be read as limited to the described order or elements unless stated to that effect. Therefore, all embodiments that come within the scope and spirit of the following claims and equivalents thereto are claimed as the invention.

An aspect provides a plumbing fixture comprising:

a water passage configured to hold water;
a first plate shaped according to a cross section of the water passage and spaced at a first distance from the water passage; and
a second plate shaped according to the cross section of the water passage and spaced at a second distance from the water passage,

wherein a voltage between the first plate and the second plate is generated based on the water in the water passage.

The first plate may be formed from a first metal and the second plate may be formed from a second metal.

The voltage between the first plate and the second plate may be generated based on a difference between a temperature of the water in the water passage and an ambient temperature.

The plumbing fixture may comprise a battery configured to store charge from the voltage between the first plate and the second plate.

The plumbing fixture may comprise a wireless radio operable from current induced from the voltage between the first plate and the second plate.

The plumbing fixture may comprise a controller configured to receive a user input and activate at least one electrical component from current induced from the voltage between the first plate and the second plate in response to the user input.

The plumbing fixture may comprise an indicator operable from current induced from the voltage between the first plate and the second plate.

The plumbing fixture may comprise a conditioning circuit configured to regulate current induced from the voltage between the first plate and the second plate.

The plumbing fixture may comprise a switch configured to activate at least one electrical component from current induced from the voltage between the first plate and the second plate.

The water passage may be connected to at least one of a toilet, a bidet, a shower, a lavatory, or a water heater.

An aspect provides a water consuming appliance comprising:

a water container to contain or pass water therethrough;
a first plate shaped spaced at a first distance from the water container; and
a second plate shaped at a second distance from the water container,
wherein a voltage between the first plate and the second plate is generated based on a temperature difference between the water in the water container and an ambient environment.

The water container may include a toilet tank. The water container may include a sanitary pipe.

The water container may be connected to one or more of: a bidet wand, a showerhead, a water heater and/or a lavatory.

An aspect provides a method for recovering heat from a plumbing fixture, the method comprising:

receiving sensor data for a water consuming appliance connected to the plumbing fixture;
activating a thermoelectric cell in response to the sensor data, the thermoelectric cell including a first plate shaped according to a cross section of the plumbing fixture and spaced at a first distance from the plumbing fixture and a second plate shaped according to the cross section of the plumbing fixture and spaced at a second distance from the plumbing fixture; and
applying a voltage between the first plate and the second plate to an electronic component of the water consuming appliance.

The first plate may be formed from a first metal and the second plate may be formed from a second metal.

The voltage between the first plate and the second plate may be generated based on a difference between a temperature of the water in the plumbing fixture and an ambient temperature.

An aspect provides a method for recovering heat from a plumbing fixture, the method comprising:

receiving a voltage across a thermoelectric cell associated with the plumbing fixture, the thermoelectric cell including a first plate shaped according to a cross section of the plumbing fixture and spaced at a first distance from the plumbing fixture and a second plate shaped according to the cross section of the plumbing fixture and spaced at a second distance from the plumbing fixture; and
applying a voltage between the first plate and the second plate to an electronic component associated with the plumbing fixture.

The method may comprise:

receiving sensor data for a water consuming appliance connected to the plumbing fixture; and
activating the thermoelectric cell in response to the sensor data.

An aspect provides a waste water heat recovery apparatus for a structure, the waste water heat recovery apparatus comprising:

at least one thermal radiation device;
a first connection coupled to the at least one thermal radiation device and at least one water consuming appliance; and
a second connection coupled to the at least one thermal radiation device and a sanitary path out of the structure.

The at least one thermal radiation device may be configured to heat a room.

The at least one thermal radiation device may be configured to heat a water pipe spaced apart from the waste water heat recovery apparatus.

The at least one thermal radiation device may be configured to heat a shower receptor.

The waste water heat recovery apparatus may comprise: a supply water pipe having a predetermined path through the at least one thermal radiation device.

The predetermined path may include a serpentine path. The predetermined path may include a turbulator. The predetermined path may include a wave shape.

The waste water heat recovery apparatus may comprise: a chamber adjacent to the at least one thermal radiation device, wherein the chamber includes at least a portion of the water pipe and an interstitial fluid.

The waste water heat recovery apparatus may comprise:

> a waste water pipe connecting the first connection and the second connection; and
> a chamber adjacent to the waste water pipe, wherein the chamber includes at least a portion of a supply water pipe and an interstitial fluid.

An aspect provides a waste water heat recovery apparatus for a structure, the waste water heat recovery apparatus comprising:

> a waste water plumbing fixture configured to receive waste water from at least one water consuming appliance;
> a water supply pipe configured to at least indirectly supply water to the at least one water consuming appliance; and
> a radiator configured to radiate heat from the waste water to the water of the water supply pipe.

The water supply pipe may be routed to the radiator.

The water supply pipe may connect to a water heater and the at least one water consuming appliance may be downstream of the water heater.

The radiator may further radiate heat from the waste water to an ambient environment of the radiator.

The waste water heat recovery apparatus may comprise: a bypass pipe connected to the water supply pipe, wherein the bypass pipe is configured to bypass the radiator.

The waste water heat recovery apparatus may comprise:

> a temperature sensor configured to collect sensor data for the waste water plumbing fixture or the waste water; and
> a valve configured to open the bypass pipe in response to the sensor data.

The temperature sensor may be upstream of the radiator or downstream of the radiator.

In implementations, the temperature sensor may be a first temperature sensor and the sensor data may be first sensor data and the waste water heat recovery apparatus may comprise:

a second temperature sensor configured to collect second sensor data for the water supply pipe or the water carried by the water supply pipe, wherein the valve may be configured to open the bypass pipe in response to the second sensor data.

The valve may be configured to open the bypass pipe in response to a difference between the first sensor data and the second sensor data.

An aspect provides a method for waste water heat recovery, the method comprising:

> providing a thermal connection between a waste water plumbing fixture configured to receive waste water from at least one water consuming appliance or for a water supply pipe configured to at least indirectly supply water to the at least one water consuming appliance;
> receiving sensor data for the waste water plumbing fixture or for the water supply pipe; and
> actuating a valve to open or close a bypass across the thermal connection in response to the sensor data.

The thermal connection may be implemented by a radiator configured to radiate heat from the waste water to the water of the water supply pipe.

An aspect provides a plumbing fixture comprising:

> a first pipe associated with waste water;
> a second pipe associated with a water supply; and
> an interstitial fluid between the first pipe and the second pipe and configured to improve a transfer of heat from the waste water to the water supply of the second pipe.

The second pipe may traverse a circumference of the first pipe, optionally for a plurality of revolutions.

The first pipe may be substantially vertical. Each revolution, e.g. of the plurality of revolutions, may be at a predetermined angle from a horizontal plane or a vertical plane.

The plumbing fixture may comprise a chamber enclosing the interstitial fluid, wherein the chamber supports the second pipe.

The first pipe may support the chamber.

The second pipe may include an appliance facing connection at least indirectly coupled to a water consuming appliance. The first pipe may include an appliance facing connection coupled to a drain of the water consuming appliance.

The first pipe may be connected to a sewage system.

The plumbing fixture may comprise a clamp configured to clamp the chamber to the first pipe.

The second pipe may include a water supply connection.

An aspect provides a plumbing fixture comprising:

a first pipe associated with waste water; and
a second pipe associated with a water supply and including a pipe pattern in a plurality of directions, the pipe pattern configured to improve transfer of heat from the waste water to the water of the second pipe.

The pipe pattern may include a serpentine path for a shape of the second pipe.

The pipe pattern may include a longitudinal wave pattern in a flow direction of the second pipe.

The pipe pattern may be internal to the second pipe.

The pipe pattern may be provided by a turbulator.

The pipe pattern may be defined by a flat panel heat exchanger including multiple apertures for the second pipe.

The plumbing fixture may comprise a chamber supported by the first pipe and enclosing the second pipe.

The chamber may include interstitial fluid configured to improve a transfer of heat from the waste water to the water supply.

An aspect provides a method for reducing fouling in a waste water heat recovery system, the method comprising:

receiving operational data for the waste water heat recovery system; and
actuating a cleaning system for in response to the operational data for the waste water heat recovery system.

The operational data may include a time of use, a schedule, a temperature, a volume, or an image sensor for one or more water passages of the waste water heat recovery system.

The operational data may include sensor data from a feedback sensor.

The cleaning system may be configured to treat one or more passages of the waste water heat recovery system.

The cleaning system may include an ultraviolet light internal to one or more passages of the waste water heat recovery system.

The cleaning system may include a cleaning compound dispenser.

The cleaning system may include a nanobubble generator internal to one or more passages of the waste water heat recovery system.

The cleaning system may include an ozone generator internal to one or more passages of the waste water heat recovery system.

An aspect provides a waste water recovery system comprising:

a first pipe associated with waste water; and
a second pipe associated with a water supply and including a treatment device to reduce scaling or fouling within the waste water recovery system.

The waste water recovery system may comprise: a feedback sensor configured to detect a condition in the first pipe or the second pipe, wherein the treatment device is activated in response to data from the feedback sensor.

The treatment device may include an ultraviolet light. The treatment device may include a cleaning compound dispenser. The treatment device may include a nanobubble generator.

The treatment device may include an ozone generator internal to one or more passages of the waste water heat recovery system.

An aspect provides a control system for a waste water heat recovery apparatus, the control system comprising:

at least one septic side temperature sensor configured to measure a temperature of a waste water plumbing fixture;
at least one potable side temperature sensor configured to measure a temperature of a water supply pipe; and
a controller configured to generate an alert message based on the temperature of the waste water plumbing fixture and the temperature of the water supply pipe.

The alert message may include a command for a cleaning device.

The command for the cleaning device may activate an ultraviolet light.

The command for the cleaning device may activate a cleaning compound dispenser. The command for the cleaning device may activate a nanobubble generator. The command for the cleaning device may activate an ozone generator.

The control system may comprise a communication interface configured to transmit the alert message over a network.

The alert message may be sent to a central control device for maintenance of the waste water heat recovery apparatus.

The alert message may be sent to a mobile device associated with a user of the waste water heat recovery apparatus.

The control system may comprise: a display configured to display the alert message including an indication of potential failure of the waste water heat recovery apparatus.

The at least one septic side temperature sensor may include an input side sensor for the waste water plumbing fixture and an output side sensor for the waste water plumbing fixture.

The at least one potable side temperature sensor may include an input side sensor for the water supply pipe and an output side sensor for the water supply pipe.

An aspect provides a waste water heat recovery apparatus for a structure, the waste water heat recovery apparatus comprising:

a waste water plumbing fixture configured to receive waste water from at least one water consuming appliance;
a water supply plumbing fixture configured to at least indirectly supply water to the at least one water consuming appliance; and
a controller configured to generate an alert message based on a temperature of the waste water plumbing fixture and a temperature of the water supply plumbing fixture.

The controller may include a learned model based on historical usage patterns of the waste water heat recovery apparatus.

The historical usage patterns may include historic values for the temperature of the waste water plumbing fixture and the temperature of the water supply plumbing fixture.

The learned model may include one or more thresholds for current values of the temperature of the waste water plumbing fixture and the temperature of the water supply plumbing fixture based on hourly, daily, seasonal, or annual trends.

The temperature of the waste water plumbing fixture may include sensor data from an input side sensor for the waste water plumbing fixture and sensor data from an output side sensor for the waste water plumbing fixture.

The temperature of the water supply plumbing fixture may include an input side sensor for the water supply plumbing fixture and an output side sensor for the water supply plumbing fixture.

An aspect provides a method for developing a learned model for a waste water heat recovery apparatus, the method comprising:

receiving a first plurality of temperature values for a waste water plumbing fixture from at least one septic side temperature sensor;
receiving a second plurality of temperature values for a water supply fixture from at least one potable side temperature sensor; and
generating a learned model for prediction of a failure of the waste water heat recovery apparatus based on the first plurality of temperature values and the second plurality of temperature values.

The first plurality of temperature values may include at least one input side value and at least one output side value with respect to the waste water plumbing fixture. The second plurality of temperature values may include at least one input side value and at least one output side value with respect to the water supply fixture.

An aspect provides a compost heat recovery apparatus system comprising:

a compost bin;
a pipe;
a first connection coupled to the pipe and a water supply; and
a second connection coupled to the pipe and at least one water consuming appliance,
wherein the compost bin generates heat applied to the pipe.

**Claims**

1. A plumbing fixture comprising:

a water passage configured to hold water;
a first plate shaped according to a cross section of the water passage and spaced at a first distance from the water passage; and
a second plate shaped according to the cross section of the water passage and spaced at a second distance from the water passage,
wherein a voltage between the first plate and the second plate is generated based on the water in the water passage.

2. The plumbing fixture of claim 1, wherein the first plate is formed from a first metal and the second plate is formed from a second metal.

3. The plumbing fixture of claim 1 or claim 2, wherein the voltage between the first plate and the second plate is generated based on a difference between a temperature of the water in the water passage and an ambient temperature.

4. The plumbing fixture of claim 1, claim 2 or claim 3, further comprising a battery configured to store charge from the voltage between the first plate and the second plate.

5. The plumbing fixture of any one of claims 1 to 4, further comprising a wireless radio operable from current induced from the voltage between the first plate and the second plate.

6. The plumbing fixture of any one of claims 1 to 5, further comprising:
a controller configured to receive a user input and activate at least one electrical component from current induced from the voltage between the first plate and the second plate in response to the user input.

7. The plumbing fixture of any one of the preceding claims, further comprising:

an indicator operable from current induced from the voltage between the first plate and the second plate; and/or
a switch configured to activate at least one electrical component from current induced from the voltage between the first plate and the second plate.

8. The plumbing fixture of any one of the preceding claims, further comprising:
a conditioning circuit configured to regulate current induced from the voltage between the first plate and the second plate.

9. The plumbing fixture of any one of the preceding claims, wherein the water passage is connected to at least one of a toilet, a bidet, a shower, a lavatory, or a water heater.

10. A water consuming appliance comprising:

a water container to contain or pass water therethrough;
a first plate shaped spaced at a first distance from the water container; and
a second plate shaped at a second distance from the water container,
wherein a voltage between the first plate and the second plate is generated based on a temperature difference between the water in the water container and an ambient environment.

11. The water consuming appliance of claim 10, wherein the water container is a toilet tank or a sanitary pipe.

12. The water consuming appliance of claim 10 or claim 11, wherein the water container is connected to at least one of a bidet wand, a showerhead, a water heater or a lavatory.

13. A method for recovering heat from a plumbing fixture, the method comprising:

receiving sensor data for a water consuming appliance connected to the plumbing fixture;
activating a thermoelectric cell in response to the sensor data, the thermoelectric cell including a first plate shaped according to a cross section of the plumbing fixture and spaced at a first distance from the plumbing fixture and a second plate shaped according to the cross section of the plumbing fixture and spaced at a second distance from the plumbing fixture; and

applying a voltage between the first plate and the second plate to an electronic component of the water consuming appliance.

14. The method of claim 13, wherein the first plate is formed from a first metal and the second plate is formed from a second metal.

15. The method of claim 13 or claim 14, wherein the voltage between the first plate and the second plate is generated based on a difference between a temperature of the water in the plumbing fixture and an ambient temperature.

FIG. 1

FIG. 2A

FIG. 2B

FIG. 2C

FIG. 2D

FIG. 2E

FIG. 2F

FIG. 3

FIG. 4

FIG. 5

FIG. 6

FIG. 7

FIG. 8

FIG. 9

FIG. 10

FIG. 11

**FIG. 12**

FIG. 13

FIG. 14A

FIG. 14B

82

181

FIG. 15A

82

182

FIG. 15B

94

95

95

FIG. 15C

FIG. 16

FIG. 17

FIG. 18

S101

RECEIVE SENSOR DATA ASSOCIATED WITH A WATER
CONSUMING APPLIANCE

S103

ACTIVATE A THERMOELECTRIC CELL IN RESPONSE TO THE
SENSOR DATA

S105

APPLY A VOLTAGE OR CURRENT TO THE WATER CONSUMING
APPLIANCE

FIG. 19

S201

MEASURE AT LEAST ONE TEMPERATURE FOR A POTABLE WATER SYSTEM

S203

MEASURE AT LEAST ONE TEMPERATURE FOR A WASTE WATER SYSTEM

S205

CALCULATE A RATIO BASED ON THE TEMPERATURE OF THE POTABLE WATER SYSTEM AND THE TEMPERATURE FOR THE WASTE WATER SYSTEM

S207

GENERATE AN ALERT MESSAGE IN RESPONSE TO THE RATIO AND A THRESHOLD

FIG. 20

S301

RECEIVE TEMPERATURE VALUES FOR A WASTE WATER PLUMBING FIXTURE

S303

RECEIVE TEMPERATURE VALUES FOR A WATER SUPPLY FIXTURE

S305

GENERATE A LEARNED MODEL BASED ON THE TEMPERATURE VALUES

S307

PROVIDE SUBSEQUENT TEMPERATURE VALUES TO THE LEARNED MODEL

S309

IDENTIFY A FAILURE BASED ON THE OUTPUT OF THE LEARNED MODEL

FIG. 21

S401

RECEIVE OPERATIONAL DATA FOR A WASTE WATER HEAT
RECOVERY SYSTEM

S403

ACTUATE A CLEANING SYSTEM IN RESPONSE TO THE
OPERATIONAL DATA

FIG. 22

**EUROPEAN SEARCH REPORT**

Europäisches
Patentamt
European
Patent Office
Office européen
des brevets

Application Number

EP 25 15 1227

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 205 205 915 U (QI JIAWEI) 4 May 2016 (2016-05-04) * claims 1-4; figure 1 * ----- | 1-15 | INV. F28D21/00 F24D18/00 H10N10/13 E03C1/12 F24D101/60 |
| X | KR 102 527 203 B1 (KOREA INST CIVIL ENG & BUILDING TECH [KR]) 28 April 2023 (2023-04-28) * paragraphs [0001], [0008], [0024] - [0037], [0050]; figures 2,3 * ----- | 1-15 | |
| A | US 11 415 326 B2 (RHEEM MFG CO [US]) 16 August 2022 (2022-08-16) * the whole document * ----- | 1-15 | |

TECHNICAL FIELDS
SEARCHED (IPC)

F28D
F28F
F24D
H10N
F24H
E03C

The present search report has been drawn up for all claims

| Place of search | Date of completion of the search | Examiner |
|---|---|---|
| Munich | 28 May 2025 | García Moncayo, O |

EPO FORM 1503 03.82 (P04C01)

**EP 4 589 236 A1**

## ANNEX TO THE EUROPEAN SEARCH REPORT
## ON EUROPEAN PATENT APPLICATION NO.

EP 25 15 1227

This annex lists the patent family members relating to the patent documents cited in the above-mentioned European search report.
The members are as contained in the European Patent Office EDP file on
The European Patent Office is in no way liable for these particulars which are merely given for the purpose of information.

28-05-2025

| Patent document cited in search report | | Publication date | Patent family member(s) | | Publication date |
|---|---|---|---|---|---|
| CN 205205915 | U | 04-05-2016 | NONE | | |
| KR 102527203 | B1 | 28-04-2023 | NONE | | |
| US 11415326 | B2 | 16-08-2022 | US 2022107094 A1 | | 07-04-2022 |
| | | | WO 2022076526 A1 | | 14-04-2022 |

EPO FORM P0459

For more details about this annex : see Official Journal of the European Patent Office, No. 12/82

44

**REFERENCES CITED IN THE DESCRIPTION**

**Patent documents cited in the description**

- US 63623031
- US 00301924